(19) Europäisches Patentamt
European Patent Office
Office européen des brevets

(11) **EP 2 154 940 A1**

(12) **EUROPEAN PATENT APPLICATION**
published in accordance with Art. 153(4) EPC

(43) Date of publication:
**17.02.2010 Bulletin 2010/07**

(51) Int Cl.:
*H05K 9/00* (2006.01)   *G09F 9/00* (2006.01)
*G09F 9/30* (2006.01)

(21) Application number: **08752417.9**

(22) Date of filing: **08.05.2008**

(86) International application number:
**PCT/JP2008/058526**

(87) International publication number:
**WO 2008/140007 (20.11.2008 Gazette 2008/47)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **09.05.2007 JP 2007124339**
**25.07.2007 JP 2007193107**

(71) Applicant: **Toray Industries, Inc.**
**Tokyo 103-8666 (JP)**

(72) Inventors:
• **TANAKA, Shotaro**
**Otsu-shi**
**Shiga 520-8558 (JP)**
• **OHASHI, Junpei**
**Otsu-shi**
**Shiga 520-8558 (JP)**
• **TAKADA, Yasushi**
**Otsu-shi**
**Shiga 520-8558 (JP)**

(74) Representative: **Kador & Partner**
**Corneliusstrasse 15**
**80469 München (DE)**

(54) **CONDUCTIVE BOARD, ELECTROMAGNETIC SHIELDING BOARD FOR PLASMA DISPLAY AND METHOD FOR MANUFACTURING CONDUCTIVE BOARD**

(57)    Disclosed is a metal layer laminated substrate comprising: a metal fine particle layer laminated onto at least one surface of a substrate in a random network form; a resin layer laminated at an opening portion of a network of the metal fine particle layer so as to be brought into contact with the metal fine particle layer; and a plated metal layer laminated onto the metal fine particle layer so as to be brought into contact with the resin layer, wherein a resin composing the resin layer is a resin having an anionic ionic group. The present invention provides a conductive substrate and an electromagnetic wave shielding substrate for a plasma display, which achieve high-level and uniform transparency and conductivity over a large area, are less likely to cause Moire phenomenon, and are also excellent in electromagnetic wave shielding properties and adhesion properties between layers.

Fig.1

**Description**

TECHNICAL FIELD

The present invention relates to a conductive substrate which achieves uniform transparency and conductivity over a large area and is less likely to cause Moire phenomenon, and a method for producing the same. The present invention also relates to an electromagnetic shielding substrate for a plasma display.

BACKGROUND ART

Conductive substrates are used for various equipment as its circuit materials. They are also used as electromagnetic shielding substrates and have an application for solar cells. An electromagnetic shielding substrate is used for the purpose for suppressing various electromagnetic waves radiated from electronic equipment such as household electric equipment, portable telephones, personal computers and televisions. In particular, among household electric equipment remarkably developed, strong electromagnetic waves are radiated also from flat panel display such as plasma display panels and liquid crystal televisions. In these displays, because an image is observed with a relatively small distance and, as the case may be, for a long time, an electromagnetic shielding substrate for suppressing the electromagnetic waves is needed, and investigated earnestly

When electromagnetic shielding substrates are used for plasma display panels as described above, it is required that the electromagnetic shielding substrates have uniform and high transparency over the entire display screen in order to ensure fine and uniform visibility across them. Besides, in order to prevent a defect of the shielding effect from occurring in the electromagnetic waves radiated from the display, it is required that the electromagnetic shielding substrates have uniform and high conductivity over the entire display screen.

As such electromagnetic shielding substrates, currently used are the substrates in which a cupper foil is laminated onto a plastic film and the cupper foil is then processed into a lattice form by a method of photolithography or etching. This method is a method in which a cupper foil is laminated onto the entire face and the cupper foil at opening portions is removed by etching. This method is wasteful from the standpoint of resource saving, resulting in high cost. Further, these substrates have a problem that Moire phenomenon occurs due to a regular structure of their lattice-shaped cupper foil layer.

Moire phenomenon is a "striped pattern which occurs when geometrical patterns of regularly distributed points or lines are laid one upon another". In plasma display panels, a striped pattern occurs on a screen. This is because, when an electromagnetic shielding substrate provided on a front face of a display has a regular pattern, Moire phenomenon occurs due to an interaction with regularly-arranged lattice-shaped barrier walls which separate color pixels of RGB installed on a back panel of the display.

For a method to prevent such Moire phenomenon, methods of using a pattern with a random portion have been proposed (Patent Documents 1, 2, 3 and 4).

According to the technique described in Patent Document 1, the occurrence of Moire phenomenon is suppressed by a mesh structure having a random portion. This technique is a technique in which randomization is realized by combining some opening portions with different sizes and an identical shape. Transparency increases but conductivity decreases at the portion where large openings gather, whereas, conductivity increases but transparency decreases at the portion where small openings gather, and therefore uniformity of transparency and conductivity was not high enough in a wide area. This method is a method in which a cupper foil is laminated onto the entire surface and then a mesh structure is formed by etching. Therefore, this method is wasteful from the standpoint of resource saving.

According to the technique described in Patent Document 2, a random network of a metal fine particle layer is formed using a solution which spontaneously forms an irregular network when it is applied. However, even if the technique described in Patent Document 2 was used, it was difficult to attain high-level uniformity in transparency and conductivity over a large area.

According to the technique described in Patent Document 3, a fine network structure of palladium is formed on a substrate using a spray and then a metal layer is laminated thereonto by electroless plating. This network structure is less likely to exhibit regularity, and thus the Moire phenomenon is potentially suppressed. However, since the technique fails to perform a treatment of enhancing adhesion between a substrate and a fine network structure or a metal layer, there is a possibility that the layers are easily scraped or peeled off upon handling of the substrate for the purpose of post processing.

The technique described in Patent Document 4 adopts a configuration that a siliceous layer exists on an upper layer of a random metal fine particle layer as if it covers the fine metal particle layer. Problems such as peeling and scraping of the metal fine particle layer are the ones that can be solved by the siliceous layer. However, a small thickness of the metal fine particle layer and covering the metal fine particle layer with the siliceous layer cause high surface specific resistance as high as $10^2$ to $10^3$ Ω/sq., resulting in unsatisfactory conductivity required for an electromagnetic wave shielding film for a plasma display panel. Therefore, it is considered that, when the electromagnetic wave shielding film is used for a plasma display panel, sufficient electromagnetic wave shielding function is not exhibited.

Patent Document 1: Japanese Unexamined Patent Publication (Kokai) No. 2001-343520 (page 1, claims, etc.)
Patent Document 2: Japanese Unexamined Patent Publication (Kokai) No. 2006-127929 (page 1, claims, etc.)
Patent Document 3: Japanese Unexamined Patent Publication (Kokai) No. 10-340629 (page 1, claims, etc.)
Patent Document 4: Japanese Unexamined Patent Publication (Kokai) No. 10-182191 (page 1, claims, etc.)

DISCLOSURE OF THE INVENTION

Problems to be Solved by the Invention

An object of the present invention is to overcome the above drawbacks, and to provide a conductive substrate and an electromagnetic wave shielding substrate for a plasma display which achieve uniformity in transparency and conductivity over a large are, and are also less likely to cause Moire phenomenon, something that have not been achieved easily by a conventional method, and a method for producing a conductive substrate.

Means for Solving the Problems

The conductive substrate in the first invention of the present application is a conductive substrate comprising:

a metal fine particle layer laminated onto at least one surface of a substrate in a random network form;
a resin layer laminated at an opening portion of a network of the metal fine particle layer so as to be brought into contact with the metal fine particle layer; and
a plated metal layer laminated onto the metal fine particle layer so as to be brought into contact with the resin layer, wherein a resin composing the resin layer is a resin having an anionic ionic group.

The method for producing a conductive substrate of the present invention is a method for producing a conductive substrate, which comprises a step of laminating a metal fine particle layer onto a substrate in a random network form; a step of laminating a resin layer having an anionic ionic group onto an opening portion of a network of the metal fine particle layer so as to be brought into contact with the metal fine particle layer; and a step of laminating a plated metal layer onto the metal fine particle layer so as to be brought into contact with the resin layer.
The conductive substrate in the second invention of the present application is a conductive substrate in which a metal fine particle layer is laminated onto a substrate in a network form, **characterized in that**:

a sum $(N+N_{-0.1}+N_{+0.1})$ of the number $(N)$ of an opening portion having a number maximum compactness, the number $(N_{-0.1})$ of an opening portion having a compactness 0.1 smaller than the number maximum compactness and the number $(N_{+0.1})$ of an opening portion having a compactness 0.1 larger than the number maximum compactness is 38% to 90% of a total number of the opening portion,
where a compactness of each opening portion of the network form is defined as a value calculated from the following formula (1) and rounded to one decimal place, and

$$(\text{perimeter of opening portion})^2/(4 \times \pi \times (\text{area of opening portion})) \qquad (1)$$

the number maximum compactness is a compactness where the number of the opening portions is maximized.

The method for producing a conductive substrate of the present invention is a method for producing the conductive substrate, which comprises laminating an interlayer containing a polyester resin and a crosslinking agent onto at least one surface of a substrate, and laminating a metal fine particle layer onto the surface, onto which the interlayer was laminated, in a network form.

Effects of the Invention

According to the conductive substrate in the first invention of the present application, a conductive substrate having excellent transparency, electromagnetic wave shielding properties and adhesiveness between layers are obtained by a simple production method without the occurrence of Moire phenomenon, in a conductive substrate laminated with a plated metal layer, by laminating a resin layer at an opening portion of a network of the metal fine particle layer so as to be brought into contact with the metal fine particle layer, in a conductive substrate in which a metal fine particle layer is laminated onto a substrate in a random network form.

According to another aspect of a conductive substrate in the second invention of the present application, a conductive substrate and a electromagnetic wave shielding substrate for a plasma display, which are less Moire phenomenon occurrence and have uniformity in transparency and conductivity over a wide area, are obtained by controlling network randomness within a proper range, in a conductive substrate in which a metal fine particle layer is laminated onto a substrate in a random network form.

BRIEF DESCRIPTION OF THE DRAWINGS

Fig. 1 is one example of a cross-sectional schematic view of a conductive substrate of the present invention.
Fig. 2 is one example of a metal fine particle layer having a random network structure.
Fig. 3 is one example of a metal fine particle layer having a random network structure.

Explanation of References

1. Conductive substrate
2. Substrate
3. Metal fine particle layer
4. Resin layer
5. Plated metal layer
6. Opening portion of network of metal fine particle layer

BEST MODE FOR CARRYING OUT THE INVENTION

In the first invention of the present application, a resin layer having an anionic ionic group is laminated onto a substrate at an opening portion of a network of a metal fine particle layer, which is laminated onto the substrate in a random network form. The resin layer is laminated in a state where the metal fine particle layer is substantially exposed. On the metal fine particle layer, a plated metal layer is laminated. By laminating the plated metal layer on the metal fine particle layer, conductivity of the substrate is further improved and thus the electromagnetic wave shielding properties are improved.

Herein, the state where the metal fine particle layer is substantially exposed refers to a state where the plated metal layer can be laminated onto the metal fine particle layer. In other words, it is defined as a substantially exposed state as long as the plated metal layer can be laminated onto the metal fine particle layer, even if the metal fine particle layer is partially or entirely covered thinly with the resin layer. For example, when the plated metal layer is laminated by an electroplating method, if electricity is conducted through the metal fine particle layer and electroplating is performed on the metal fine particle layer, the state can be considered to be a state where the metal fine particle layer is substantially exposed.

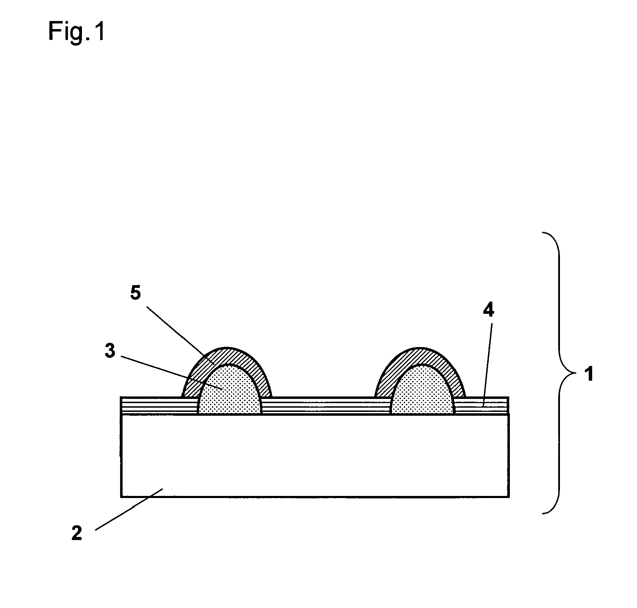

The plated metal layer is laminated so as to be brought into contact with a resin layer. One example of a cross-sectional schematic view of a conductive substrate according to the present aspect is shown in Fig. 1. However, the present invention is not limited to the form of this drawing. As shown in Fig. 1, the state where the plated metal layer is laminated so as to be brought into contact with the resin layer refers to a state where a plated metal layer 5 is laminated only onto a metal fine particle layer 3 and is scarcely laminated onto an opening portion of a network, but is contacted with a resin layer 4 laminated onto the opening portion. In other words, the resin layer 4 is contacted with the substrate 2, the metal fine particle layer 3 and the plated metal layer 5. It is not necessary that the substrate is directly contacted with the resin layer. When an under coat layer is provided on the substrate, the resin layer may be contacted with the under coat layer.

When the plated metal layer is not laminated onto an opening portion of a network formed by the metal fine particle layer as much as possible and laminated only onto the metal fine particle layer, conductivity improves without decreasing transparency of the substrate.

With the laminated constitution of the present aspect, a transparent conductive substrate having the following feature can be obtained by a simple and easy method. First, since a network has a random shape, a conductive substrate free from Moire can be obtained. Since the plated metal layer is laminated, a conductive substrate having sufficient conductivity and electromagnetic wave shielding properties can be obtained. Since a resin layer having an anionic ionic group forms a structure contacted with the substrate, the metal fine particle layer and the plated metal layer, a conductive substrate having excellent adhesion properties between layers can be obtained.

In order to realize the above laminate structure, each layer is laminated in the following order. First, a metal fine particle layer is laminated onto a substrate. Next, a resin layer is laminated at an opening portion of a network of the metal fine particle layer so as to be brought into contact with the metal fine particle layer. At this time, in order to laminate a plated metal layer on the metal fine particle layer in later times, the resin layer is laminated to form a state where the metal fine particle is substantially exposed. Next, a plated metal layer is laminated onto the metal fine particle layer so as to be brought into contact with the resin layer. When the plated metal layer is laminated onto the metal fine particle layer, the plated metal layer grows on the metal fine particle layer not only in a thickness direction, but also in a width direction, ending up to be contacted with the resin layer.

When each layer has the above laminated constitution, the resin layer plays a bonding role between the respective layers including the substrate, and an excellent adhesive force of each layer is exhibited. The resin layer is formed by a resin having an anionic ionic group. In view of adhesion with the plated metal layer, it becomes important that the resin layer is formed by the resin having an anionic ionic group due to the following reason.

An outermost surface of the metal fine particle layer is very brittle and, even if the plated metal layer is laminated onto the metal fine particle layer, the plated metal layer is peeled off together with the outermost surface of the brittle metal fine particle layer. The present inventors have intensively studied and found that, when the laminated constitution of the present invention is employed and a resin having an anionic ionic group is used as the resin forming the resin layer, an exfoliation problem of the plated metal layer is solved. The mechanism is not known clearly, but it is presumed as follows.

When the resin having an anionic ionic group is used as the resin layer, it is presumed that an adhesive force of an interface between the plated metal layer and the resin layer is improved due to an ionic interaction and thus an adhesive force between the two layers is improved. It is also presumed that the resin layer is also contacted with the base material and the metal fine particle layer, and plays a bonding role capable of exhibiting an excellent adhesive force with all of these layers.

Preferred is a structure in which the resin layer is partially intercalated between particles of the metal fine particle layer, since it enables to increase the adhesive force. In order to form such a structure, it is preferred to use a method in which the metal fine particle layer is laminated onto the substrate in a random network form, and a solution of a resin is applied thereon and dried. When the solution of the resin is applied after laminating the metal fine particle layer, the solution of the resin is intercalated into empty spaces between particles of the metal fine particle layer. When the solution is dried, the resin is likely to be solidified in a state that the resin is partially intercalated between particles of the metal fine particle layer. The reason why excellent adhesion properties is exhibited by forming the structure in which the resin layer is partially intercalated between particles of the metal fine particle layer is presumably because the resin takes a structure as if an anchor is dropped into the metal fine particle layer.

In the case of forming a resin layer by application, a state that the resin layer is laminated at an opening portion of the metal fine particle layer and that the metal fine particle layer is substantially exposed is created by adjusting a concentration of the solid content, including a resin, in the solution and a thickness to be coated.

The resin forming the resin layer may be either a thermoplastic resin or a thermocurable resin as long as it is a resin having an anionic ionic group, and may be either an organic resin or an inorganic resin. Two or more kinds of resins having an anionic ionic group can be used in combination. The resin layer may be a laminate of two or more layers. The resin layer is preferably transparent so as to improve transparency of a conductive substrate.

Examples of the anionic ionic group include those of carboxylic acid, sulfonic acid, phosphoric acid, silicic acid, sulfuric acid ester, phosphoric acid ester, and a metal salt or organic salt thereof. Examples of a counter ion composing a metal salt include metal ions of Li, Na, Mg, Al, Zn, Cu, Ni, Fe and Cr. Examples of an ion composing an organic salt include an organoammonium ion.

Examples of the resin having an anionic ionic group include, but are not limited to, a polymer having an anionic ionic group in the molecule, and a polymer having an anionic ionic group in the side chain. For example, a polyanion such as polyacrylic acid, polymethacrylic acid, polystyrenesulfonic acid or polyvinylphosphoric acid, an acrylic resin having an anionic ionic group, gelatine or polyester are exemplified. In addition, a polyester, an acryl-modified polyester and polyurethane obtained by copolymerzing a compound containing carboxylic acid, sulfonic acid, or an alkali metal salt, an alkaline earth metal salt or an ammonium salt thereof are exemplified as well.

Among these, preferred are those obtained by copolymerizing a polyester, an acryl-modified polyester or a polyurethane with a compound containing sulfonic acid such as sulfoterephthalic acid, 5-sulfoisophthalic acid, 4-sulfoisophthalic acid, 4-sulfonaphthalene-2,7-dicarboxylic acid, sulfo-p-xylylene glycol or 2-sulfo-1,4-bis(hydroxyethoxy)benzene, or an alkali metal salt, alkaline earth metal salt or ammonium salt thereof.

As the resin composing the resin layer, a resin having an anionic ionic group may be used alone, or in combination with other resins, and the proportion of the resin having an anionic ionic group is preferably 30% by weight or more based on the entire resin layer, since it gives satisfactory adhesion with the plated metal layer. The proportion of the resin having an anionic ionic group is more preferably 50% by weight or more, and still more preferably 70% by weight or more.

The resin layer can contain various additives, for example, dispersing agents, surfactants, protective resins, antioxidants, heat stabilizers, weatherability stabilizers, ultraviolet absorbers, pigments, dyes, organic or inorganic fine particles, fillers and antistatic agents.

The resin forming the resin layer is prefereably a water-borne resin. The reason is as follows. It was described above that, in the present invention, a preferred lamination method of the resin was performed by forming a metal fine particle layer, applying a solution of the resin and drying it. In contrast, according to this method, the resin is likely to be overlaid on the metal fine particle layer and thus it becomes difficult to substantially expose the metal fine particle layer. Therefore, when a water-borne resin is selected as the resin forming the resin layer and an aqueous solution of the resin is applied on the metal fine particle layer, the aqueous solution of the resin is likely to be repelled from the metal fine particle layer due to the high surface tension of water and thus it becomes possible that the resin layer is not easily overlaid on the metal fine particle layer. At this time, when the metal fine particles composing the metal fine particle layer are dispersed in an organic solvent slightly soluble in water, it becomes more difficult to compatibilize the metal fine particle layer with water. It is therefore preferred because it allows the aqueous solution of the water-borne resin to be repelled from the metal fine particle layer.

Examples of the organic solvent slightly soluble in water include hydrocarbons such as benzene, toluene, xylene, ethylbenzene, trimethylbenzene, methylcyclohexane, methylcyclopentane, hexane, heptane, octane and decane; halogen-based solvents such as chloroform, 1,1-dichloroethane, 1,2-dichloroethane, trichloroethylene, 1,1,2-trichloroethane, dichloromethane, nitromethane and dibromomethane; ketones such as methyl-n-butyl ketone, ethyl-n-butyl ketone, diisobutyl ketone, diisopropyl ketone, cyclopentanone, cyclohexanone and methyl isobutyl ketone; esters such as n-propyl acetate, isopropyl acetate and n-butyl acetate; ethers such as isopropyl ether, ethyl-n-butyl ether, n-butyl ether and ethylene glycol-di-n-butyl ether; and alcohols such as n-hexyl alcohol and n-octyl alcohol.

In the second invention of the present application, it is important that a sum ($N + N_{-0.1} + N_{+0.1}$) of the number (N) of opening portions having a number maximum compactness, the number ($N_{-0.1}$) of opening portions having a compactness 0.1 smaller than the number maximum compactness and the number ($N_{+0.1}$) of opening portions having a compactness 0.1 larger than the number maximum compactness is from 38% to 90% of a total number of the opening portions, when the compactness defined by the formula (1) below is determined for each opening portion in a network form, and the compactness with which the count of the opening portions is maximized is defined as a number maximum compactness, in the conductive substrate with the metal fine particle layer laminated onto the substrate in a network form.

Compactness: a value calculated from the following formula (1) and rounded to one decimal place

$$(perimeter\ of\ opening\ portion)^2/(4 \times \pi \times (area\ of\ opening\ portion)) \qquad (1)$$

wherein compactness denotes an indicator expressing conciseness of a shape calculated from the above formula (1). When the shape is a circle, the compactness becomes 1 and shows a minimum value.

When $N + N_{-0.1} + N_{+0.1}$ is less than 38% of the number of the opening portions, randomness of a network shape increases and thus Moire phenomenon is less likely to occur. However, the kinds of an opening portion shape becomes too much and there arises a problem that uniformity of conductivity and transparency over a wide area is damaged.

When $N + N_{-0.1} + N_{+0.1}$ is more than 90% of the number of the opening portions, randomness of the network shape is damaged and thus there arises a problem that Moire phenomenon is likely to occur.

Therefore, it is important that $N + N_{-0.1} + N_{+0.1}$ is from 38% to 90% of the total number of the opening portions. $N + N_{-0.1} + N_{+0.1}$ are preferably from 40 to 85%, and more preferably 45 to 80%, of the total number of the opening portions.

A compactness with which the count is maximized (number maximum compactness) is preferably from 1.1 to 1.7. More preferably, a number maximum compactness is from 1.2 to 1.4, and particularly preferably, a number maximum compactness is 1.3 due to the following reason. When the number maximum compactness is within the above range, Moire phenomenon does not occur, and also a conductive substrate having high-level conductivity and transparency, and satisfactory intrasurface uniformity thereof can be easily obtained.

When there are 2 or more values in terms of a number maximum compactness, a compactness having a number N where $N + N_{-0.1} + N_{+0.1}$ becomes maximum is defined as a number maximum compactness. When there are 2 or more values in terms of a number maximum compactness and there are 2 or more compactnesses with an identical value of $N + N_{-0.1} + N_{+0.1}$, the compactness close to 1.3 is defined as a number maximum compactness.

The method of laminating a metal fine particle layer on a substrate is not particularly limited, but is preferably a method forming a network of fine particles by utilizing a phenomenon in which fine particles gather locally to form a network line by applying a metal fine particle layer-forming solution on a substrate, so-called self-assembly phenomenon.

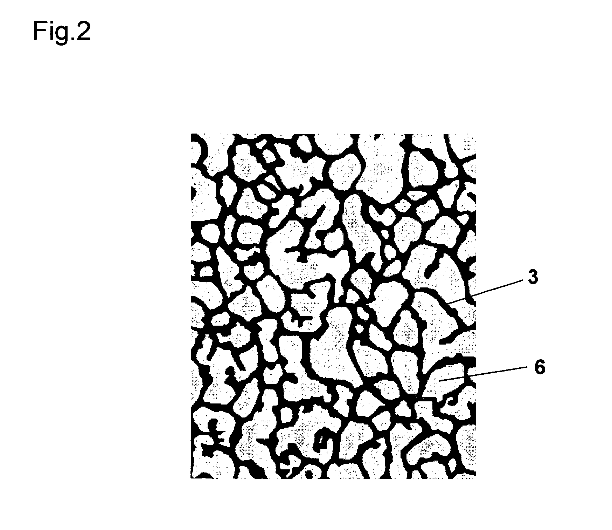

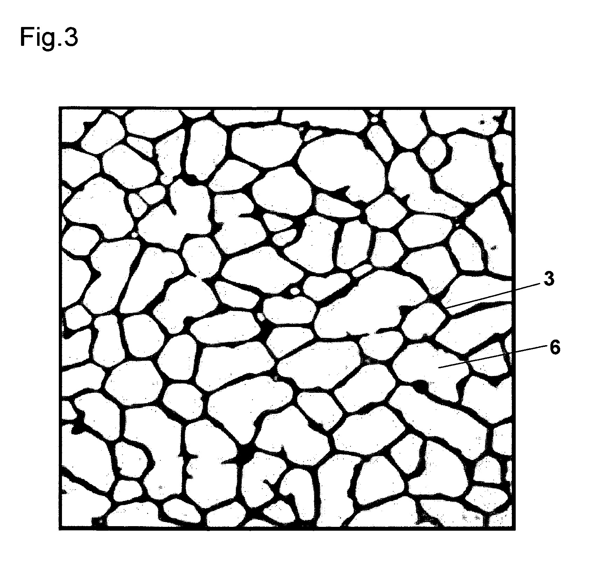

The method of laminating a metal fine particle layer on a substrate is not particularly limited as long as it forms a structure in which a metal fine particle layer is connected in a random network form on at least one surface of a substrate. Herein, the random network structure refers to those observed in a state that the shape of the network structure is uneven in shape and size of an air gap portion, in an observation image by a scanning electron microscope. One example of a random network structure is shown in Fig. 2 and Fig. 3, but is not limited thereto.

Examples of the method of laminating a metal fine particle layer on a substrate include (i) a method in which a solution of metal fine particles is printed in a network form, (ii) a method in which a metal fine particles is laminated onto the entire surface of a substrate and then the metal fine particle layer is physically scraped or chemically etched so as to give a network form, and (iii) a method in which a network-shaped groove is preliminarily formed on at least one surface of a substrate by digging, chopping or embossing and then the groove is filled with a solution of metal fine particles. However, since a line width is increased by the printing method, transparency may decrease. Since a straight line is likely to be obtained by the method of etching or forming a groove, severe Moire may occur severely because of poor randomness.

The method of laminating a metal fine particle layer on a substrate is preferably a method forming a network of fine particles by utilizing a phenomenon in which fine particles gather locally to form a network line by applying a metal fine particle layer-forming solution on a substrate, so-called self-assembly phenomenon. According to such a method, a network easily becomes random and a line width easily become thin. Also, a network structure having satisfactory conductivity is easily formed through a step of treating the layer with an organic solvent described hereinafter and a subsequent step of treating it with an acid. In short, since a substrate satisfying all of randomness, satisfactory transparency and conductivity is easily obtained, a method using a "self-assembly solution" is preferred.

Herein, the "self-assembly solution" is a solution which naturally forms a network structure on a substrate when the solution is applied on the substrate and then allowed to stand. When a network structure is formed using the self-assembly solution, for example, a solution (metal colloid solution) containing particles as a main component, comprising metal fine particles and an organic component such as a dispersing agent, can be used. As the solvent of the metal colloid solution, water or various organic solvents can be used. As such a solution, for example, CE103-7 manufactured by Cima NanoTech can be used.

When a metal fine particle layer is laminated onto a substrate in a network form using a self-assembly solution, it is preferred to control an atmosphere which meets specific conditions (humidity on the substrate: 1 to 85%RH) from the beginning of application of a self-assembly solution to formation of a network shape of the self-assembly solution. The humidity on the substrate is preferably from 10 to 70%RH, more preferably from 20 to 60%RH, and particularly preferably from 30 to 50%RH.

By adjusting the humidity on the substrate within the above range, it is easy to control $N + N_{-0.1} + N_{+0.1}$ within a range of 38 to 90% of the total number of the opening portions, and to control the number maximum compactness within a range from 1.1 to 1.7 when the metal fine particle layer is laminated onto the substrate in a network form.

When the humidity on the substrate is less than 1%, the total light transmittance decreases and transparency of the network-shaped metal fine particle laminate substrate decreases. When the humidity on the substrate is more than 85%RH, structures connected in a network form are separated and therefore network conductivity decreases.

The humidity on the substrate is measured by the following procedure using a hygrometer. In a production process in which a network-shaped metal fine particle layer is laminated onto a substrate, the humidity was measured at the position 1 cm above the center of a surface of a substrate on which a metal fine particle solution is applied, using a hygrometer.

It is preferred to control the temperature on the substrate within a range from 15 to 100°C from the beginning of application of a self-assembly solution to formation of a network shape of the self-assembly solution. The temperature on the substrate is preferably from 15 to 50°C, more preferably from 20 to 40°C, and particularly preferably from 20 to 30°C.

By adjusting the temperature on the substrate within the above range, it is easy to control $N + N_{-0.1} + N_{+0.1}$ within a range of 38 to 90% of the total number of the opening portions, and to control the number maximum compactness within a range from 1.1 to 1.7, when the metal fine particle layer is laminated onto the substrate in a network form.

When the temperature on the substrate is lower than 15°C or higher than 100°C, transparency of the network-shaped metal fine particle laminate substrate decreases and conductivity decreases.

The temperature on the substrate is measured by the following procedure. In a production process in which a network-shaped metal fine particle layer is laminated onto a substrate, the temperature was measured at the position 1 cm above the center of a surface of a substrate on which a metal fine particle solution is applied, using a thermometer.

It is preferred that a number average particle diameter of the metal fine particles is from 0.001 to 0.3 $\mu$m and a maximum particle diameter is less than 1.0 $\mu$m. When a self-assembly solution containing the metal fine particles is used, it is easy to control randomness of the metal fine particle layer. Therefore, it is favorable because a conductive substrate having excellent transparency and conductivity is easily obtained. The number average particle diameter of the metal fine particles is preferably from 0.001 to 0.2 μm, and more preferably from 0.002 to 0.15 μm.

Particle size distribution of the metal fine particles is not particularly limited. However, it is preferred to have particles with uniform particle size, since it is easy to control randomness of the metal fine particle layer as the particle size is more uniform and particle size distribution is smaller.

Examples of the metal used for the metal fine particles include, but are not limited to, platinum, gold, silver, copper, nickel, palladium, rhodium, ruthenium, bismuth, cobalt, iron, aluminum, zinc and tin. These metal fine particles may be used alone, or two or more kinds of them may be used in combination.

It is important for the conductive substrate of the present invention that the metal fine particle layers are continuously connected without breakage. When the metal fine particle layers are continuously connected, it becomes possible to apply a current to the entire surface of the metal fine particle layer only by taking conduction from one point on the metal fine particle layer, and to allow satisfactory conductivity to be exhibited.

Surface specific resistance of the substrate laminated with the metal fine particle layer is preferably 40 Ω/sq. or less. It is preferred because a conductive substrate having high electromagnetic wave shielding properties is obtained by adjusting the surface specific resistance to 40 Ω/sq. or less. The surface specific resistance is more preferably 30 Ω/sq. or less, and still more preferably 10 Ω/sq. or less. The surface specific resistance can be measured by using Rolester EP (model number: MCP-T360, manufactured by Mitsubishi Chemical Corporation) in conformity with JIS-K-7194 after a measuring sample was allowed to stand in an ordinary state (23°C, relative humidity of 65%) for 24 hours. The surface specific resistance is preferably 40 Ω/sq. or less since it is easy to perform electroplating described hereinafter. The lower the surface specific resistance is, the better it becomes. Since it is difficult by a current technique to adjust the surface specific resistance to less than 0.001 Ω/sq. using the metal fine particle layer, the lower limit is about 0.001 Ω/sq.

A total light transmittance of the conductive substrate of the present invention is preferably 50% or more, more preferably 65% or more, and particularly prefereably 75% or more. It is not preferred that the total light transmittance is less than 50%, because the transparency of the conductive substrate is low. The higher the total light transmittance is, the better it becomes. Since it is difficult by a current technique to adjust the total light transmittance to 95% or more when the metal fine particle layer is provided, the upper limit is considered to be about 95%.

The metal fine particle layer of the present invention can contain, in addition to metal fine particles, other various additives, for example, dispersing agents, surfactants, protective resins, antioxidants, heat stabilizers, weatherability stabilizers, ultraviolet absorbers, pigments, dyes, organic or inorganic fine particles, fillers and antistatic agents. However, the content of the metal fine particles is preferably 50% by weight or more in all components of the metal fine particle layer due to the following reason. When the content of the metal fine particles in the metal fine particle layer is 50% by weight or more, the surface specific resistance of the metal fine particle layer is likely to decrease.

Although the metal composing the plated metal layer is not particularly limited, Cu, Ni, Cr, Zn, Au, Ag, Al, Sn, Pt, Pd, Co, Fe and In can be used. These metals may be used alone, or two or more kinds of them may be used in combination. Among these metals, Cu is preferably used in view of conductivity, and electroplating properties.

Since the metal fine particle layer of the present invention has conductivity, a plated metal layer can be laminated by using electroplating. It is preferred because the plated metal layer is laminated only onto the metal fine particle layer, by a method that an opening portion of a network formed by the metal fine particle layer is formed from a material having electrical insulation properties and the plated metal layer is laminated by electroplating. As described above, the surface specific resistance of the substrate laminated with the metal fine particle layer is preferably 40 Ω/sq. or less, more preferably 30 Ω/sq. or less, and still more preferably 10 Ω/sq. or less. The state where the surface specific resistance is more than 40 Ω/sq. is not preferred, since a load incurred by resistance increases upon electroplating, and thus current distribution needs to be done under a high voltage.

In the present invention, before the metal fine particle layer is subjected to electroplating, it is allowed to perform a treatment of decreasing the surface specific resistance, in increasing conductivity of the metal fine particle layer by using a known method such as heat treatment, light beam processing or erectrifying processing. It is particularly preferred to decrease the surface specific resistance by a method of treating metal fine particles with an acid. Since the method of treating with an acid can increase conductivity of metal fine particles under mild treating conditions, it can be suitably employed even if a material having poor heat resistance and light resistance, such as a thermoplastic resin, is used as a substrate. The method is preferable in view of productivity, since it does not require a complicated apparatus or process.

The acid in the present invention is not particularly limited and can be selected from various organic and inorganic acids. Examples of the organic acid include acetic acid, oxalic acid, propionic acid, lactic acid and benzenesulfonic acid. Examples of the inorganic acid include hydrochloric acid, sulfuric acid, nitric acid and phosphoric acid. These acids may be either strong acids or weak acids. The acid is preferably an acid selected from acetic acid, hydrochloric acid, sulfuric acid and an aqueous solution thereof, and more preferably an acid selected from hydrochloric acid, sulfuric acid and an aqueous solution thereof.

A step of treating a metal fine particle layer with an acid may be performed between any steps as long as it is performed before lamination of a plated metal layer. For example, a metal fine particle layer may be laminated onto a substrate in a network form, followed by a treatment with an acid, or metal fine particles may be laminated onto the entire surface of a substrate and, after treating with an acid, a metal fine particle layer may be formed in a network form by etching. Preferred is a method in which a metal fine particle layer is formed in a network form and a resin layer is formed, and then a treatment with an acid is performed before a step of laminating a plated metal layer, since it is excellent in effect of increasing conductivity and is efficient in view of productivity. When another step such as a step of laminating a resin layer is inserted between a step of treating a metal fine particle layer with an acid and a step of laminating a plated metal layer, the effect of increased conductivity exerted by treating the metal fine particle layer with an acid may deteriorate. Therefore, it is preferred to treat the metal fine particle layer with an acid immediately before laminating the plated metal layer. Before or after the acid treatment, the substrate may be dried or subjected to a heat treatment or an ultraviolet irradiation treatment.

The treating time with an acid may be several minutes or less. Even if the treating time is prolonged, the effect of improving conductivity may not be improved or the effect of improving conductivity may deteriorate. The treating time with an acid is preferably from 15 seconds to 60 minutes, more preferably from 15 seconds to 30 minutes, still more preferably from 15 seconds to 2 minutes, and particularly preferably from 15 seconds to 1 minute.

The treating temperature with an acid may be a normal temperature. When the treatment is performed at a high temperature, vapor of the acid is generated to cause deterioration of a peripheral metal apparatus. When a thermoplastic resin film is used as a base material, the base material may be whitened to damage transparency. The treating temperature is preferably 40°C or lower, more preferably 30°C or lower, and more preferably 25°C or lower. The lower limit of the treating temperature is preferably 5°C or higher, and more preferably 10°C or higher.

The method of the acid treatment is not particularly limited, but exemplified by a method of immersing a substrate laminated with a metal fine particle layer in an acid or a solution of an acid, a method of applying an acid or a solution of an acid on a metal fine particle layer, or a method of spraying vapor of an acid or a solution of an acid to a metal fine particle layer. Among these methods, a method of directly bringing a substrate into contact with a liquid of an acid, such as a method of immersing a substrate laminated with a metal fine particle layer in a solution of an acid or a method of applying an acid or a solution of an acid on a metal fine particle layer, is preferred, since it is excellent in the conductivity improving effect. That is, as a condition of the acid treatment, it is preferred that a substrate laminated with a metal fine particle layer is immersed in a solution of an acid, or an acid or a solution of an acid is applied on a metal fine particle layer, at a temperature of 40°C or lower.

When a solution of an acid is used, the concentration of the acid is preferably 10 mol/L or less, more preferably 5 mol/L or less, and still more preferably 1 mol/L or less. When the acid solution has a high concentration, operability may be lowered and productivity may deteriorate. When a thermoplastic resin film is used as a base material, the base material may be whitened to damage transparency. When the concentration of the acid is too low, treatment effect with an acid is low. Therefore, the concentration of the acid is preferably 0.05 mol/L or more, and more preferably 0.1 mol/L or more.

In the case of a metal fine particle layer composed of metal fine particles having a number average particle diameter of 0.2 $\mu$m or less, sufficient effect is exerted by the acid treatment, even if an acid having a low concentration is used. Therefore, the number average particle diameter of the metal fine particles is particularly preferably 0.2 $\mu$m or less.

It is preferred to treat a metal fine particle layer with an organic solvent before treating it with an acid, since more excellent conductivity is easily obtained. Regarding the stage where a metal fine particle layer is treated with an organic solvent, a metal fine particle layer may be treated with an organic solvent after laminating it on a substrate in a network form, or metal fine particles may be laminated onto the entire surface of a substrate and, after treating it with an organic solvent, a metal fine particle layer may be formed in a network form by etching. Among these methods, a method of laminating metal fine particles on a substrate in a network form and treating it with an organic solvent before laminating a resin layer is preferably used since it is excellent in effect of increasing conductivity and is efficient in view of productivity. When the metal fine particle layer is treated with an organic solvent after laminating a resin layer, the resin layer may be dissolved by the organic solvent in some cases. Before or after treating the layer with an organic solvent, the substrate laminated with the metal fine particle layer may be dried or subjected to a heat treatment or an ultraviolet irradiation treatment.

The treating temperature with an organic solvent may be a normal temperature. If the treatment is performed at a high temperature, when a thermoplastic resin film is used as a base material, the base material may be whitened to damage transparency. The treating temperature is preferably 40°C or lower, more preferably 30°C or lower, and still more preferably 25°C or lower. The lower limit of the treating temperature is preferably 5°C or higher, and more preferably 10°C or higher.

The method of the treatment with an organic solvent is not particularly limited, but exemplified by a method of immersing a substrate laminated with a metal fine particle layer in a solution of an organic solvent, a method of applying an organic solvent on a metal fine particle layer, or a method of spraying vapor of an organic solvent to a metal fine particle layer. Among these methods, a method of immersing a substrate laminated with a metal fine particle layer in a solution of an organic solvent or a method of applying an organic solvent on a metal fine particle layer is preferred, since it is excellent in the conductivity improving effect.

Examples of the organic solvent include alcohols such as methyl alcohol, ethyl alcohol, isopropyl alcohol, n-butanol, isobutanol, 3-methoxy-3-methyl-1-butanol, 1,3-butanediol and 3-methyl-1,3-butanediol; ketones such as acetone, methyl ethyl ketone, methyl isobutyl ketone, cyclohexanone and cyclopentanone; esters such as ethyl acetate and butyl acetate; alkanes such as hexane, heptane, decane and cyclohexane; dipolar aprotic solvents such as N-methyl-2-pyrrolidone, dimethylformamide, dimethylacetamide and dimethyl sulfoxide; toluene, xylene, aniline, ethylene glycol butyl ether, ethylene glycol, ethylether, ethylene glycol methyl ether, chloroform, and and mixed solvents thereof. Among these organic solvents, an organic solvent containing ketone, ester or toluene is preferred because of excellent conductivity improving effect. Ketones are particularly preferred.

The organic solvent diluted with water may also be used. A mixing ratio of the organic solvent to water is preferably 5/95 or more, more preferably 50/50 or more, still more preferably 70/30 or more, and most preferably 100/0, in terms of a weight ratio.

When the metal fine particle layer is composed of noble metal fine particles, since it serves as a catalyst for electroless plating, it becomes possible to perform electroless plating. Examples of the noble metal include Au, Ag, Pt, Pd, Rh, Os, Ru and Ir.

When electroless plating is performed, if an element serving as a catalyst for electroless plating exists on a substrate surface, a plated metal layer is also laminated at an opening portion of a network formed by a metal fine particle layer and thus transparency of the substrate decreases. Therefore, it is preferred that an element serving as a catalyst for electroless plating, for example, a metal such as Au, Ag, Pt or Pd, does not exist on a substrate surface.

In electroless plating, it is necessary to prolong a plating time so as to increase a thickness of a plated metal layer. In this case, a plating nuclei may be formed on foreign matters adhered to an opening portion to form a plated metal layer at the opening portion. When the plated metal layer is formed at the opening portion, transparency of the substrate decreases. Therefore, when the thickness of the plated metal layer is intended to increase, electroplating is better than electroless plating.

The thickness of the plated metal layer is preferably 1.5 $\mu$m or more, more preferably 2 $\mu$m or more, and still more preferably 3 $\mu$m or more. Although the upper limit of the thickness is not particularly limited, the thickness is preferably 15 $\mu$m or less, and more preferably 10 $\mu$m or less, because when the thickness of the plated metal layer increases, a line width of the plated metal layer is likely to increase, resulting in decrease in transparency of the substrate. It is preferred that the thickness of the plated metal layer is 1.5 $\mu$m or more since magnetic field shielding properties are excellent in a low frequency region when the conductive substrate of the present invention is used for electromagnetic wave shielding substrate.

When the thickness of the plated metal layer is 1.5 $\mu$m or more, expansion of the plated metal layer in a width direction necessarily increases. As a result, when a pattern with regularity is used, Moire phenomenon is likely to occur. However, since a random layer is formed in the present invention, Moire does not occur even if the thickness of the plated metal layer is increased. As a result, it becomes possible to reconcile magnetic field shielding properties in a low frequency region and Moire resistance.

The surface specific resistance of at least one surface of a conductive substrate laminated with a plated metal layer is preferably less than 0.5 $\Omega$/sq., more preferably 0.2 $\Omega$/sq. or less, still more preferably 0.1 $\Omega$/sq. or less, and most preferably 0.05 $\Omega$/sq. or less. When the surface specific resistance is 0.5 $\Omega$/sq. or more, it may become impossible to exhibit satisfactory magnetic field shielding properties in a low frequency region.

In order to adjust the surface specific resistance of the substrate to 0.5 $\Omega$/sq. or less, it is preferred to use metals selected from Cu, Ni, Cr, Zn, Au, Ag, Al, Sn, Pt, Pd, Co, Fe and In alone or in combination of two or more kinds as metals composing the plated metal layer" although there is no particular limitation. Among these metals, Cu is preferably used. By adjusting the thickness of the plated metal layer to 1.5 $\mu$m or more using the above metals, the surface specific resistance is suitably adjusted to 0.5 $\Omega$/sq. or less.

The substrate used in the present invention is not particularly limited and various substrates such as glass and resin can be used. Two or more kinds of substrates such as glass and resin may be used in combination by laminating them or by other means. The substrate is preferably a thermoplastic resin film in view of transparency, flexibility and processability.

To the thermoplastic resin film, various additives, for example, antioxidants, heat stabilizers, weatherability stabilizers, ultraviolet absorbers, organic lubricants, pigments, dyes, organic or inorganic fine particles, fillers, antistatic agents and nucleating additives, may be added as long as the characteristics are not adversely affected.

The thickness of the thermoplastic resin film is not particularly limited and is appropriately selected according to applications and kinds. In view of mechanical strength and handling properties, the thickness is preferably from 10 to 500 $\mu$m, more preferably 38 to 250 $\mu$m, and most preferably from 75 to 150 $\mu$m. A thermoplastic resin film may be single-layered film or a composite film obtained by coextrusion. The film can be used by laminating it using various methods.

The thermoplastic resin film in the present invention is a generic term of a film which is melted or softened by heat and is not particularly limited. Typical examples of usable thermoplastic resin film include a polyolefin film such as polyester film, polypropylene film or polyethylene film; an acrylic film such as polylactic acid film, polycarbonate film, polymethyl methacrylate film or polystyrene film; a polyamide film such as nylon film; a polyvinyl chloride film; a polyurethane film; a fluorine-based film; and a polyphenylene sulfide film. These films may be formed from either a homopolymer or a copolymer. Among these films, a polyester film, a polypropylene film and a polyamide film are preferred in view of mechanical properties, dimensional stability and transparency, and a polyester film is particularly preferred in view of mechanical strength and versatility.

When the polyester film is used as a substrate, a self-assembly phenomenon tends to occur, which produces a proper distribution in a shape of the network opening portions upon application of the above self-assembly solution. Whereby, it is easy to control $N + N_{-0.1} + N_{+0.1}$ of the conductive substrate within a range of 38 to 90% of the total number of the opening portions, and to control the number maximum compactness within a range from 1.1 to 1.7. From such a point of view, the polyester film is preferably used as the substrate. When the substrate is not a polyester film, it is difficult to control $N + N_{-0.1} + N_{+0.1}$ of the conductive substrate within a range of 38 to 90% of the total number of the opening portion, and to control the number maximum compactness within a range from 1.1 to 1.7.

In the polyester film, polyester is a generic term of polymers that have an ester bond as a main bond chain of a main chain, and those containing at least one kind of a constituent component selected from ethylene terephthalate, propylene terephthalate, ethylene-2,6-naphthalate, butylene terephthalate, propylene-2,6-naphthalate and ethylene-$\alpha$, $\beta$-bis(2-chlorophenoxy)ethane-4,4'-dicarboxylate, as a main constituent component, can be preferably used. These constituent components may be used alone, or two or more kinds of them may be used in combination. Among these components, a polyester containing ethylene terephthalate as a main constituent component, namely, polyethylene terephthalate, is used particularly preferably when quality and economic efficiency are comprehensively taken into account. When heat or contraction stress is applied to the substrate, polyethylene-2,6-naphthalate is preferred because it has excellent heat resistance and rigidity. These polyesters may be partially (preferably 20 mol% or less) copolymerized with other dicarboxylic acid components or diol components.

The intrinsic viscosity (measured in o-chlorophenol at 25°C) of the polyester is preferably within a range from 0.4 to 1.2 dl/g, and more preferably from 0.5 to 0.8 dl/g, so as to carry out the present invention.

It is preferred that the polyester film is biaxially oriented. A biaxially oriented polyester film is generally a polyester film obtained by stretching an unstretched polyester sheet or film in a longitudinal direction as well as a width direction by about 2.5 to 5 times, subjected to a heat treatment, thereby completing crystal alignment, which exhibits a biaxially oriented pattern by wide angle x-ray diffraction.

When an interlayer containing a polyester resin and a crosslinking agent is laminated between a substrate and a metal fine particle layer, a self-assembly phenomenon is likely to occur so as to form a proper distribution in a shape of the network opening portions upon applying the above self-assembly solution. Whereby, it is easy to control $N + N_{-0.1} + N_{+0.1}$ of the conductive substrate within a range of 38 to 90% of the total number of the opening portion, and to control the number maximum compactness within a range from 1.1 to 1.7, making the procedure favorable. The interlayer may be laminated onto one surface or both sides of a substrate, if only the interlayer is mounted at least on the side laminated with the metal fine particle layer.

A mechanism why the above effect is exerted when the interlayer is provided and the self-assembly solution is applied is not known clearly, but is considered as follows. When the self-assembly solution is applied, a surface functional group of the interlayer as well as the properties such as surface wetting tension exert an influence on the self-assembly solution, which triggers the occurrence of the self-assembly phenomenon, leading to form a proper distribution in a shape of the network opening portions.

Therefore, it is allowed to laminate another layer between the interlayer and the metal fine particle layer, but the case where thickness of the another layer is too thick is unfavorable, because the effect of easily inducing the self-assembly phenomenon and thus forming a proper distribution in a shape of the network opening portions is diminished , when the self-assembly solution is applied. When another layer is provided between the interlayer and the metal fine particle layer, the thickness is preferably 0.5 $\mu$m or less, more preferably 0.2 $\mu$m or less, and still more preferably 0.1 $\mu$m or less. If another layer is that which is soluble in a solvent contained in the self-assembly solution, it becomes difficult to prevent the self-assembly solution from the influence by a surface functional group of the interlayer as well as the properties such as surface wetting tension.

Examples of another layer provided between the interlayer and the metal fine particle layer include an under coat layer for enhancing adhesion between the substrate and the metal fine particle layer, an antistatic layer, a release layer, hydrophilized layer and a hydrophobic layer.

Regarding a polyester resin and a crosslinking agent, which compose the interlayer, the amount (solid content) of the crosslinking agent is preferably 0.01 part by weight or more and 50 parts by weight or less, and more preferably 1 to 25 parts by weight, based on 100 parts by weight of the polyester resin of the interlayer. When the ratio of the polyester resin to the crosslinking agent of the interlayer is within the above range, it becomes more easy to obtain a network in which $N + N_{-0.1} + N_{+0.1}$ of the conductive substrate is controlled within a range of 38 to 90% of the total number of the opening portion, and the number maximum compactness is controlled within a range from 1.1 to 1.7.

A total component ratio of the polyester resin and the crosslinking agent contained in the interlayer is preferably 50% by weight or more and 100% by weight or less, more preferably 80% by weight or more and 100% by weight or less, and still more preferably 90% by weight or more and 100% by weight or less, based on 100% by weight of the total components of the interlayer.

Herein, the polyester resin used in the interlayer has an ester bond in the main chain or the side chain. The polyester resin used in the interlayer is preferably a copolymer containing a component selected from terephthalic acid, isophthalic acid and sebacic acid as an acid-derived component, and a component selected from ethylene glycol, diethylene glycol, 1,4-butanediol and neopentyl glycol as a diol component.

In view of strength and heat resistance of the interlayer, it is preferred to use a polyester resin wherein an aromatic dicarboxylic acid-derived component accounts for 30 mol% or more, more preferably 35 mol% or more, and particularly preferably 40 mol% or more, of the total acid-derived component.

It is preferred that the polyester resin and the crosslinking agent, which compose the interlayer, are used as a coating solution in the form of an aqueous solution. When used as the aqueous solution, it becomes easy to mix each component, whereby, it becomes easy to control $N + N_{-0.1} + N_{+0.1}$ of the conductive substrate within a range of 38 to 90% of the total number of the opening portion, and to control the number maximum compactness within a range from 1.1 to 1.7.

In this case, in order to facilitate water solubilization or water dispersin of the polyester resin, it is preferred to copolymerize a compound having a sulfonic acid group or a trihydric or higher polyhydric carboxylate group as an acid component of the polyester resin, in an amount of 0.5 mol% to 40 mol% based on the total acid-derived components.

Examples of the compound having a sulfonate group include sulfoterephthalic acid, 5-sulfoisophthalic acid, 4-sulfoisophthalic acid, or an alkali metal salt, alkaline earth metal salt and ammonium salt thereof. Examples of the compound having a trihydric or higher polyhydric carboxylate group include trimellitic acid, trimellitic anhydride, pyromellitic acid, pyromellitic anhydride, 4-methylcyclohexene-1,2,3-tricarboxylic acid, trimesic acid, or an alkali metal salt, alkaline earth metal salt and ammonium salt thereof.

A glass transition temperature (Tg) of the polyester resin used for the interlayer is preferably from 5 to 55°C. When Tg is less than 5°C, the blocking phenomenon may occur between substrates when the substrates having an interlayer are laid one upon another. When Tg exceeds 55°C, the polyester resin may be inferior in stability and water dispersibility. Tg is preferably from 10 to 50°C, and more preferably from 15 to 40°C.

In the present invention, as the polyester resin used in the interlayer, a modified polyester copolymer, for example, a block copolymer or graft copolymer modified with acryl, urethane or epoxy can be used.

The crosslinking agent used for the interlayer of the present invention is the kind that is able to develop a crosslinking reaction with a polyester resin, or other resins used in the interlayer. For example, it is possible to use a melamine compound, an oxazoline-based crosslinking agent, an isocyanate-based crosslinking agent, an epoxy-based crosslinking agent, a methyloled or alkyloled urea-based, acrylamide-based, polyamide-based resins, an amideepoxy compound, various silane coupling agents and various titanate-based coupling agents. A melamine compound or an oxazoline-based crosslinking agent is particularly preferred since it is excellent in compatibility with the polyester resin used for the interlayer, and thus a network shape with controlled randomness is easily obtained.

As the melamine compound, for example, a methyloled melamine derivative obtained by condensing melamine and formaldehyde, a compound etherified partially or entirely by reacting the methyloled melamine with a lower alcohol, and a mixture thereof can be used. Also, a monomer, a condensate composed of a dimer or higher multimer, or a mixture thereof can be used. As the lower alcohol used for etherification, for example, methyl alcohol, ethyl alcohol, isopropyl alcohol, n-butanol and isobutanol can be used.

As the melamine compound, a melamine resin having a functional group such as imino group, methylol group, methoxymethyl group or butoxymethyl group is preferably used. As the melamine resin having a functional group, an imino group type methylated melamine resin, a methylol group type melamine resin, a methylol group type methylated melamine resin and a complete alkyl type methylated melamine resin are preferably used. Among these resins, an imino group type melamine resin and a methyloled melamine resin are more preferred. In order to promote thermocuring of the melamine compound, for example, an acidic catalyst such as p-toluenesulfonic acid may be used.

The oxazoline-based crosslinking agent is preferably composed of an oxazoline group-containing copolymer obtained by copolymerzing at least one monomer having an oxazoline group with at least one other monomer.

As the monomer having an oxazoline group, 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline and 2-isopropenyl-5-ethyl-2-oxazoline can be used alone, or a mixture of two or more kinds of them can also be used. Among these monomers, 2-isopropenyl-2-oxazoline is preferred since it is industrially available.

Examples of other monomers used as the oxazoline-based crosslinking agent include acrylic acid esters or methacrylic acid esters such as methyl acrylate, methyl methacrylate, ethyl acrylate, ethyl methacrylate, butyl acrylate, butyl methacrylate, 2-ethylhexyl acrylate and 2-ethylhexyl methacrylate; unsaturated carboxylic acids such as acrylic acid, methacrylic acid, itaconic acid and maleic acid; unsaturated nitriles such as acrylonitrile and methacrylonitrile; unsaturated amides such as acrylamide, methacrylamide, N-methylolacrylamide and N-methylolmethacrylamide; vinyl esters such as vinyl acetate and vinyl propionate; vinyl ethers such as methyl vinyl ether and ethyl vinyl ether; olefins such as ethylene and propylene; halogen-containing-$\alpha,\beta$-unsaturated monomers such as vinyl chloride, vinylidene chloride and vinyl fluoride; and $\alpha,\beta$-unsaturated aromatic monomers such as styrene and $\alpha$-methylstyrene. These monomers can be used alone, or a mixture of two or more kinds of them can be used.

The thickness of the interlayer is preferably from 0.001 to 1 $\mu$m. When the thickness of the interlayer is less than 0.001 $\mu$m, it may be difficult to control $N + N_{-0.1} + N_{+0.1}$ of the conductive substrate within a range of 38 to 90% of the total number of the opening portion, and to control the number maximum compactness within a range from 1.1 to 1.7. When the thickness of the interlayer is more than 1 $\mu$m, an adverse influence may be exerted on physical properties of the substrate. The thickness of the interlayer is preferably from 0.05 to 0.6 $\mu$m, and more preferably from 0.08 to 0.4 $\mu$m.

Lamination of an interlayer on a polyester film is preferably performed as follows; an interlayer-forming coating solution is applied on one surface or both sides of a polyester film before crystal alignment is completed, followed by stretching it in at least one direction and subjecting it to a heat treatment. Taking productivity into account, a method of providing an interlayer by a coating method during a film-forming step is used particularly preferably.

It is preferred to laminate an interlayer on a polyester film before crystal alignment is completed, since it increases an interfacial adhesive strength between the polyester film and the interlayer and prevents peeling and scraping from occurring easily upon post processing.

It is preferred that wetting tension of the substrate and/or the interlayer is 40 mN/m or more, since a self-assembly phenomenon is likely to occur so as to form a proper distribution in a shape of the network opening portions upon application of the above self-assembly solution, whereby, it is easy to control $N + N_{-0.1} + N_{+0.1}$ of the conductive substrate within a range of 38 to 90% of the total number of the opening portion, and to control the number maximum compactness within a range from 1.1 to 1.7.

When wetting tension of the substrate and/or the interlayer exceeds 73 mN/m, randomness of a network shape excessively increases and Moire phenomenon hardly occurs. However, uniformity of conductivity and transparency over a wide area may be damaged and therefore the wetting tension is preferably 73 mN/m or less.

It is also preferred that wetting tension is adjusted to 40 mN/m or more by subjecting a substrate or interlayer surface having wetting tension of less than 40 mN/m to a corona discharge treatment, or an electric discharging treatment under a nitrogen atmosphere or a carbon dioxide atmosphere.

On the conductive substrate of the present invention and the electromagnetic wave shielding substrate for a plasma display, various layers may be laminated, in addition to the substrate, the metal fine particle layer, the metal layer and the interlayer. For example, an under coat layer may be provided between the substrate and the metal fine particle layer so as to improve tight adhesion, or a protective layer may be provided on the metal layer such as a plated metal layer. Also, an adhesive layer, a release layer, a protective layer, a tackifying layer or a weatherable layer may be provided on one surface or both sides of the substrate.

The metal layer such as metal fine particle layer or plated metal layer may be subjected to an antidazzling treatment or may be provided with an antidazzle layer. For example, blackening treatment by oxidation of metals, black plating of chromium or nickel alloys, and application of a black or dark color ink can be performed.

It is preferred to adjust a maximum reflectance of a visible ray region on a surface laminated with a network shape to 20% or less, by subjecting the plated metal layer to an antidazzling treatment or laminating the antidazzle layer. It is preferred to impart such antidazzle properties, since when an electromagnetic wave shielding substrate for a display is mounted on a front surface of the display, problems such as poor visibility of images and characters caused by reflection of the substrate are remedied. When the maximum reflectance of the visible ray region is more than 20%, visibility of images and characters may become worse due to reflection of the substrate. The maximum reflectance of the visible ray region is preferably 15% or less, more preferably 10% or less, and still more preferably 5% or less.

The method for producing a conductive substrate of the present invention will be explained more specifically, but is not limited thereto.

A melt-extruded polyester film before crystal orientation is stretched by about 2.5 to 5 times in a longitudinal direction. An interlayer-forming solution is continuously applied on a monoaxially oriented film. The polyester film coated with the solution is dried while passing through a zone heated stepwise and stretched by about 2.5 to 5 times in a width direction. Furthermore, the film was continuously introduced into a heating zone at 150 to 250°C thereby completing crystal orientation to form a biaxially oriented polyester film laminated with an interlayer.

Next, a self-assembly solution containing silver fine particles dispersed therein is applied on the interlayer and a silver fine particle layer is laminated in a network form. The whole film is immersed in acetone and allowed to stand for about several seconds to 1 minute thereby treating the silver fine particle layer with an organic solvent. The organic solvent adhered to the film is dried and the whole film is immersed in 0.1 N hydrochloric acid and allowed to stand for about several seconds to 60 minutes thereby treating the silver fine particle layer with an acid. The film was taken out, washed with water, immersed in a copper sulfate solution and then electrolytic copper plating is performed to laminate a 2 μm thick electrolytic copper plated layer on the metal fine particle layer, followed by washing with water and further drying.

The conductive substrate of the present invention achieves high-level uniformity in transparency and conductivity over a large area and is less likely to cause Moire phenomenon and therefore can be suitably used as an electromagnetic wave shielding member used for a plasma display panel or a flat panel display of a liquid crystal television, and also can be suitably used for various conductive substrates for circuit materials and solar batteries.

[Method for determining properties and method for evaluating advantages]

The methods for determining properties and methods for evaluating advantages of conductive substrates prepared in the respective Examples and Comparative Examples are as follows.

(1) Number average particle diameter of metal fine particles

A solution dispersed with metal fine particles was applied on a copper mesh, and by observing it by a transmission-type electron microscope (Model: H-7100FA, manufactured by Hitachi Co., Ltd.) at a magnification of 40,000X. The diameters of 100 metal fine particles were measured, and the average value thereof was defined as the number average particle diameter and also the particle diameter, which is the largest among the particle diameters of 100 metal fine particles, was defined as a maximum particle diameter.

(2) Compactness

Using a digital microscope VHX-200 manufactured by KEYENCE CORPORATION, a sample surface was observed at a magnification of 200X and picture data were stored. Next, the stored picture data were selected and displayed on a display screen. Using a measuring tool built inn an apparatus, luminance extract was performed and was binarized into back (line portion) and white (opening portion). In that case, a luminance range was set to 195 to 255. Next, a white spot (noise) of an area 400 pixel or less existing in a black portion (line portion) was deleted by "small particle deletion" processing, and a black spot (noise) of an area 400 pixel or less existing in a white portion (opening portion) was deleted by "stopgap" processing. Next, the opening portion, which is not entirely displayed because it is cut by a frame of a display screen, was converted into the black portion by "deletion" processing. Subsequently, an area and a peripheral length were determined by "collective calculation" processing and a value was calculated from the following formula (1) and rounded to one decimal place thereby determining compactness of all opening portions existing on the display screen.

$$\text{(peripheral length of opening portion)}^2/(4 \times \pi \times \text{(area of opening portion))} \qquad (1)$$

In the present invention, a compactness with respect to 100 or more opening portions was determined per one sample, and $N + N_{-0.1} + N_{+0.1}$ was determined.

(3) Surface specific resistance

Surface specific resistance of a substrate before or after lamination of a plated metal layer was measured. After these samples were allowed to stand in an ordinary state (23°C, relative humidity of 65%) for 24 hours, the measurement was performed under the atmosphere based on JIS-K-7194-1994, using Rolester EP (model number: MCP-T360, manufactured by Mitsubishi Chemical Corporation).

One sample was measured in the present invention and five-point measurement was performed per one sample and an average of measured values at five points was adopted as surface specific resistance. When a metal fine particle layer is laminated onto both surfaces of the substrate, an average of measured values at five points of one surface, and an average of measured values at five points of the other side were respectively determined and surface specific resistance every one surface was determined. The upper limit of the measurement of this meter is $1.999 \times 10^6$ Ω/sq. and, when surface specific resistance of a sample exceeds the upper limit, it was judged "immeasurable". The sample having surface specific resistance of 5 Ω/sq. or less has satisfactory conductivity.

(4) Standard deviations in surface specific resistance

First, a sample having an area of 630 cm$^2$ (identical to an area of A4 size) or more was made and was equally divided into 25 compartments and the measurement was performed three times at one point near a center in each compartment in the same manner as in (3) Surface specific resistance, and then an average was determined. Next, standard deviations were calculated using each average determined at 25 compartments, and thus standard deviations in surface specific resistance were obtained. The sample having standard deviations of less than 1 was rated "pass" because of satisfactory intrasurface uniformity in conductivity.

(5) Total light transmittance

A total light transmittance was measured by using a full-automatic direct-reading haze computer "HGM-2DP" manufactured by Suga Test Instruments Co., Ltd. after a sample was allowed to stand in an ordinary state (23°C, relative humidity of 65%) for 2 hours. An average of three measured values was adopted as a total light transmittance of the sample. When a metal fine particle layer is laminated only onto one surface of a substrate, the conductive substrate was set so that a light entered from the side of the surface laminated with the metal fine particle layer. The sample having a total light transmittance of 50% or more has satisfactory transparency.

(6) Standard deviation in total light transmittance

First, a sample having an area of 630 cm$^2$ (identical to an area of A4 size) or more was made and was equally divided into 25 compartments and a total light transmittance was measured three times at one point near a center in each compartment in the same manner as in (5) Total light transmittance, and then an average was determined. Next, standard deviations were calculated using each average determined at 25 compartments, and thus standard deviations in the total light transmittance were obtained. The sample having standard deviations of less than 1 was rated "pass" because of satisfactory intrasurface uniformity in transparency.

(7) Observation of network shape

A surface of a conductive substrate was observed by an electron microscope (LEICA DMLM, manufactured by Leica Microsystems) at a magnification of 100X and a shape of a network was confirmed.

(8) Observation of laminate structure

After cutting out a cross section of a conductive substrate, the cross section was observed by a transmission electron microscope (H-7100FA, manufactured by Hitachi, Ltd.) at a magnification of 10,000X and a cross-sectional structure was confirmed.

(9) Thickness of plated metal layer

After cutting out a cross section of a substrate, the cross section was observed by a transmission electron microscope (H-7100FA, manufactured by Hitachi, Ltd.) at a magnification of 10,000X. Among cross sections of the observed network, one cross section is selected, and the measurement is performed, where $T_t$ denotes a thickness of a portion in which the total thickness of a metal fine particle layer and a plated metal layer is maximized, while $T_m$ denotes a thickness of a portion in which a thickness of a metal fine particle layer is maximized. $(T_t-T_m)$ denotes a thickness of a plated metal layer on the cross section. This operation was performed with respect to 10 cross sections and an average of ten measured values was adopted as a thickness of the plated metal layer. The thickness in this measurement is defined as a distance in a thickness direction with a substrate as the origin, the thickness direction being vertical to the substrate. When a random network layer is laminated onto both surfaces of a substrate, an average of one surface and an average of the other surface were respectively determined and a thickness every one surface was determined.

(10) Adhesion properties of substrate before lamination of plated metal layer laminate

When a metal fine particle layer was easily peeled off before lamination of a plated metal layer, a network was broken and surface specific resistance decreases. Therefore, adhesion properties before lamination of plated metal layer were evaluated by measuring a change in surface specific resistance before and after a treatment in the same manner as in (3) Surface specific resistance.
The treatment was performed by pressing a cotton portion of a cotton swab (Johnson cotton swab, manufactured by Johnson & Johnson K.K.) against a substrate under a load of 200 g such that the substrate is vertical to the cotton swab and rubbing reciprocatively ten times (at a rate of 10 cm/s) under a given load. The case where a value of surface specific resistance after the treatment is not more than 5 times a value of surface specific resistance before the treatment was rated "A", while the case where a value of surface specific resistance after the treatment is not less than 5 times a value of surface specific resistance before the treatment was rated "B". The symbol "A" means satisfactory adhesion properties.

(11) Adhesion properties of conductive substrate after lamination of plated metal layer laminate

A substrate laminated with a plated metal layer was cut into a size measuring 100 mm $\times$ 100 mm. Using a cellophane tape manufactured by Nichiban Co., Ltd., the cut substrate was stuck on a glass plate measuring 400 mm in length, 300 mm in width and 5 mm in thickness in the vicinity of a center so as not to cause lifting of four edges of the substrate. Subsequently, the cellophane tape was cut into a size measuring 18 mm in width and 250 mm in length and one end (25 mm) in a length direction of the cellophane tape was stuck on a plated conductive substrate. After pressing the stuck surface by reciprocatively moving a rubber roller three times under a load of 20 N, the cellophane tape was removed from the substrate by pulling up at a breath within 1 second in a direction vertical to the substrate while holding an end portion of the portion on which the cellophane tape is not stuck. After removing the cellophane tape as described above, the portion measuring 18 mm in width and 25 mm in length, on which the cellophane tape was stuck, was observed. The case where an area of the remained plated Cu layer accounts for 70% or more of the area before removal was rated "A", while the case where an area of the remained plated Cu layer accounts for 70% or less of the area before removal was rated "B". The symbol "A" means satisfactory.

(12) Resistance against Moire phenomenon

The resistance against Moire phenomenon was determined by using a high vision plasma display TH-42PHD7 produced by Matsushita Electric Industrial Co., Ltd. as a plasma display, holding a conductive substrate schematically in parallel to an image plane displayed with an image in front of the image plane, rotating the substrate by an angle of 360 degrees while maintaining the schematic parallel condition of the image plane and the substrate surface, and observing whether Moire phenomenon was exhibited or not during the rotation. The case where Moiré phenomenon is not observed was rated "A", while the case where Moiré phenomenon is observed was rated "B". In the case where a random network layer was laminated only onto one surface of a substrate, the conductive substrate was held so that the surface side on which the random network layer was not laminated faced to the display screen.

(13) Electromagnetic wave shielding properties

A conductive substrate was cut into a size measuring 20 cm $\times$ 20 cm and electromagnetic wave shielding properties were measured by a KEC method of Kansai Electronic Industry Development Center. The measurement was performed at a frequency within a range from 0.1 to 1,000 MHz. Regarding electric field shielding properties, electric field shielding properties at 300 MHz were evaluated. Regarding magnetic field shielding properties, in order to evaluate magnetic field shielding properties in a low frequency region, magnetic field shielding properties at 10 MHz were evaluated. In the evaluation by the KEC method, the case where the electric shielding effect of 40 dB or more was exhibited at 300 MHz and the magnetic shielding effect of 5 dB or more was exhibited at 10 MHz was rated "pass". In both measurements of electric shielding properties and magnetic field shielding properties, the measurement was performed three times per one sample and an average was determined.

(14) Maximum reflectance in visible ray region

A maximum reflectance in a visible ray region of a conductive substrate was determined by measuring a network layer side of the conductive substrate using a recording spectrophotometer, Model U-3410, manufactured by Hitachi, Ltd. The measurement was performed in a visible ray region of 380 nm to 780 nm and a largest reflectance in the measuring range was adopted as a maximum reflectance in a visible ray region. The measurement was performed three times per one sample and an average was determined. A back surface of a measuring surface of a test piece for measurement was colored with Black Magic Marker (registered trademark) so as to eliminate back side reflection. When a network layer is laminated onto both surfaces, since the measurement is performed every one surface, a separate test piece was prepared.

(15) Measurement of wetting tension of surface

After a sample was allowed to stand in an ordinary state (23°C, relative humidity of 50%) for 6 hours, a surface wetting tension of the sample was measured under the same atmosphere based on JIS-K-6768 (1999).

First, a sample is placed on a base of a hand coater such that a measured surface faces upward, and several droplets of a mixed solution for a surface wetting tension test are dropped. Immediately, the solution is spread by pulling a wire bar capable of applying in a WET thickness of 12 μm. The surface wetting tension is judged by observing a liquid membrane of the mixed solution for the test in a bright place in a state of the liquid membrane after 2 seconds. When the liquid membrane maintains an applied state for 2 seconds or more without being broken, it is judged to be wetted. When a wetted state is maintained for 2 seconds or more, the same test is performed using a mixed solution having a high surface wetting tension. In contrast, when the liquid membrane is broken within 2 seconds, the same test is performed using a mixed solution having a low surface wetting tension. This operation is repeated and a mixed solution having a maximum surface wetting tension is selected from among mixed solutions capable of wetting a surface of the same for 2 seconds or more, and then the surface wetting tension is adopted as the surface wetting tension of the sample. A maximum surface wetting tension by this measuring method is 73 mN/m.

(16) Humidity on substrate

In a production process in which a metal fine particle layer is laminated onto a substrate, humidity on the substrate at the position of a height of 1 cm above a substrate laminated with the metal fine particle layer was measured by CLIMOMASTER (MODEL 6531, manufactured by KANOMAX JAPAN INC.). The humidity was measured at the position of a height of 1 cm above a center of a surface of the substrate formed with the metal fine particle layer was measured for 15 seconds or more, and the value obtained after stabilization was adopted as a measured value.

(17) Temperature on substrate

In a production process in which a metal fine particle layer is laminated onto a substrate, a temperature on the substrate at the position of a height of 1 cm above a substrate laminated with the metal fine particle layer was measured by CLIMOMASTER (MODEL 6531, manufactured by KANOMAX JAPAN INC.). The temperature was measured at the position of a height of 1 cm above a center of a surface of the substrate formed with the metal fine particle layer was measured for 15 seconds or more, and the value obtained after stabilization was adopted as a measured value.

EXAMPLES

The present invention will be explained based on Examples.

(Metal fine particle layer-forming solution 1)

As a metal fine particle layer-forming solution 1, a silver fine particle layer-forming solution XA-9053 manufactured by FUJIKURAKASEI CO., LTD. was used. Silver fine particles had a number average particle diameter of 0.04 μm and a maximum particle diameter of 0.2 μm.

(Metal fine particle layer-forming solution 2)

As a metal fine particle layer-forming solution 2, a silver fine particle layer-forming self-assembling solution prepared from silver fine particles dispersed in toluene (CE103-7, manufactured by Cima NanoTech) was used. Silver fine particles had a number average particle diameter of 0.08 μm and a maximum particle diameter of 0.2 μm.

(Electrolytic copper plating solution 1)

6 L of a copper sulfate solution SG (manufactured by Meltex Inc.) was poured into 7 L of water, followed by stirring. After adding 2.1 L of 97% sulfuric acid (sulfuric acid of 97%, SP grade, manufactured by Ishizu Seiyaku Co.), 28 mL of 1 N hydrochloric acid (manufactured by NACALAI TESQUE, INC., N/1-hydrochloric acid) was added. Furthermore, each 100 mL of COPPER GLEAM CLX-A and CLX-C (manufactured by and Haas Electronic Materials CMP Technologies) as a copper sulfate plating brightener were added in this order and water was finally added to make up the entire solution to 20 L.

(Interlayer-forming solution 1)

A high-solid type amino resin manufactured by CYTEC"CYMEL®"325 (imino group type methylated melamine) was used as a melamine compound 1. The melamine compound 1 as a crosslinking agent was diluted with a mixed solvent (10/90 (weight ratio)) of isopropyl alcohol and water such that the solid content becomes 3% by weight. Then, the following polyester solution 1 was mixed with the melamine compound 1 diluted with the mixed solvent of isopropyl alcohol and water such that a weight ratio of the solid content (polyester resin/melamine compound) becomes 80/20 to give an interlayer-forming solution 1. Polyester resin solution 1: aqueous solution (solid content of 3% by weight) of a polyester resin comprising the following acid components and diol components

| Acid components | |
|---|---|
| Terephthalic acid | 88 mol% |
| 5-sodiumsulfoisophthalic acid | 12 mol% |
| Diol components | |
| Ethylene glycol | 95 mol% |
| Diethylene glycol | 5 mol% |

(Interlayer-forming solution 2)

The melamine compound 1 as a crosslinking agent was diluted with a mixed solvent (10/90 (weight ratio)) of isopropyl alcohol and water such that the solid content becomes 3% by weight. Then, the following acrylic resin emulsion 1 was mixed with the melamine compound 1 diluted with the mixed solvent of isopropyl alcohol and water such that a weight ratio of the solid content (acrylic resin/melamine compound) becomes 85/15 to give an interlayer-forming solution 2. Acrylic resin emulsion 1: water-borne emulsion (solid content of 3% by weight) comprising the following acrylic resins

| Methyl methacrylate | 65 mol% |
|---|---|
| Butyl acrylate | 32 mol% |
| Acrylic acid | 1 mol% |
| N-methylolacrylamide | 2 mol%. |

(Resin layer-forming solution 1)

A water-borne urethane resin dispersion having an anionic ionic group (HYDRAN (registered trade mark) AP-201, manufactured by Dainippon Ink and Chemicals, Incorporated.) was used as a resin layer-forming solution 1.

(Resin layer-forming solution 2)

A water-borne urethane resin dispersion having an anionic ionic group (TAKELAC (registered trade mark) W-6010, manufactured by Mitsui Takeda Chemicals, Inc) was used as a resin layer-forming solution 2.

(Resin layer-forming solution 3)

A water-borne urethane resin dispersion having an anionic ionic group (TAKELAC (registered trade mark) XW-75-X35, manufactured by Mitsui Takeda Chemicals, Inc) was used as a resin layer-forming solution 3.

(Resin layer-forming solution 4)

An aqueous solution (solid content of 15% by weight) of a polyester resin comprising the following acid components and diol components was used as a resin layer-forming solution 4.

Polyester resin:

| Acid components | |
|---|---|
| Terephthalic acid | 88 mol% |

(continued)

Acid components
    5-sodiumsulfoisophthalic acid   12 mol%
Diol components
    Ethylene glycol   95 mol%
    Diethylene glycol   5 mol%

(Resin layer-forming solution 5)

A 1,2,4-trimethylbenzene solution (solid content of 3% by weight) of polystyrene was used as a resin layer-forming solution 5.

(Example 1)

Polyethylene terephthalate resin pellets were sufficiently vacuum-dried, charged to an extruder, melted at 285°C and then extruded into a sheet from a T-shape die. The obtained sheet was solidified with cooling by winding it on a mirror-finished casting drum having a surface temperature of 25°C using an electrostatic charge casting method to obtain a non-oriented film. The non-oriented film was heated to 90°C and oriented by 3.3 times in a longitudinal direction to give a uniaxially-oriented film.

Next, the interlayer-forming solution 1 was applied onto one surface of the film. The film was then introduced into a pre-heating zone by holding it with a clip and dried at 90°C, oriented by 3.5 times in a width direction in a heating zone of 105°C and subjected to a heat treatment in a heating zone of 220°C thereby completing crystal orientation to obtain a biaxially-oriented polyethylene terephthalate film laminated with an interlayer. The film surface had wetting tension of 46 mN/m.

The metal fine particle layer-forming solution 1 was printed in a network form as shown in Fig. 2 on one surface of the biaxially-oriented polyethylene terephthalate film by screen printing. The film was dried at 150°C for 1 minute to obtain a substrate in which a silver fine particle layer was laminated in a network form. The network had a line thickness of 2 $\mu$m and a line width of 50 $\mu$m. Next, as an acetone treatment, the whole film was immersed in acetone (SP grade, manufactured by NACALAI TESQUE, INC.) at 25°C for 30 seconds. The film was taken out and dried at 25°C for 3 minutes. As an acid treatment, the whole film was subsequently immersed in 1 N hydrochloric acid (N/1-hydrochloric acid, manufactured by NACALAI TESQUE, INC.) at 25°C for 1 minute. The film was taken out and washed with water. The film was dried at 150°C for 1 minute to obtain a conductive substrate. The surface specific resistance was 5 $\Omega$/sq. The interlayer had a thickness of 0.09 $\mu$m.

(Example 2)

A biaxially-oriented polyethylene terephthalate film laminated with an interlayer produced in the same manner as in Example 1 was prepared. The interlayer laminated surface of the film was subjected to a hydrophilization treatment such that wetting tension of the surface became 73 mN/m. The metal fine particle layer-forming solution 2 was applied on the hydrophilized layer of the film. After letting it stand for 10 minutes under an environment at a temperature of 25°C on the substrate and humidity of 55%RH, silver fine particle layer was laminated in a network form, followed by a treatment at 150°C for 2 minutes.

As the acetone treatment, the whole film was immersed in acetone (SP grade, manufactured by NACALAI TESQUE, INC.) at 25°C for 30 seconds. The film was taken out and dried at 25°C for 3 minutes. As the acid treatment, the whole film was subsequently immersed in 1 N hydrochloric acid (N/1-hydrochloric acid, manufactured by NACALAI TESQUE, INC.) at 25°C for 1 minute. The film was taken out and washed with water. The film was dried at 150°C for 2 minutes to obtain a conductive substrate. The surface specific resistance was 4 $\Omega$/sq.

(Examples 3 to 8)

In the same manner as in Example 2, six different samples were prepared to obtain samples of Examples 3 to 8.

(Example 9)

In order to laminate a metal layer onto the silver fine particle layer of the sample (conductive substrate) produced in Example 2, electrolytic copper plating was performed for 14 minutes by applying a current of 0.3 A per 100 cm$^2$ of

the film using the electrolytic copper plating solution. The film was taken out, washed with water and dried at 120°C for 1 minute to obtain a conductive substrate laminated with a plated metal layer.

The conductive substrate laminated with the plated metal layer had surface specific resistance of 0.08 Ω/sq., a standard deviation of the surface specific resistance of 0.011, a total light transmittance of 74% and a standard deviation of the total light transmittance of 0.85. It was a substrate excellent in conductivity and transparency, and also in intrasurface uniformity of conductivity and transparency. As a result of the evaluation on Moire phenomenon, Moire phenomenon did not occur.

(Comparative Example 1)

In the same manner as in Example 1, except that the interlayer-forming solution 1 was not applied, a biaxially oriented polyethylene terephthalate (biaxially oriented polyethylene terephthalate film having no interlayer) was obtained.

On the biaxially oriented polyethylene terephthalate film, a 12 μm thick copper foil (manufactured by Furukawa Circuit Foil Co., Ltd.) was laminated using a two-component type adhesive for dry laminate (base resin AD-76P1/curing agent CAT-10L, manufactured by Toyo-Morton, Ltd.).

Next, a photoresist was laminated onto the copper foil surface, exposed to light and then developed in a lattice pattern having a line width of 10 μm and a line pitch of 300 μm (the resist was developed so as to remain a line portion of 10 μm and to remove other portions).

Then, the copper foil was etched for 1.5 minutes by a shower method using a ferric chloride solution adjusted at 35 to 40°C, and the copper foil where no resist is remained was removed, followed by washing with water and further drying. Finally, the photoresist remaining on the copper foil was removed to obtain a substrate laminated with the copper foil.

This sample showed a value of $N + N_{-0.1} + N_{+0.1}$ greater than 90% of the total number of opening portions. As a result of the evaluation on resistance against Moire phenomenon, it was found that Moire occurred.

(Comparative Example 2)

In the same manner as in Example 1, except that the interlayer-forming solution 2 was used, a biaxially oriented polyethylene terephthalate film having an interlayer was produced. This film surface had wetting tension of 37 mN/m. In the same manner as in Example 2, a substrate laminated with a silver fine particle layer was produced using this film.

This sample showed a value of $N + N_{-0.1} + N_{+0.1}$ less than 38% of the total number of opening portions, was inferior in conductivity and transparency, showed large standard deviations in surface specific resistance and a total light transmittance, and was inferior in intrasurface uniformity of transparency and conductivity.

(Comparative Example 3)

In the same manner as in Example 2, except that the metal fine particle layer-forming solution 2 was applied on a substrate and allowed to stand for 10 minutes under an environment at a temperature of 12°C and humidity of 88%RH to laminate a silver fine particle layer in a network form, a conductive substrate laminated with the silver fine particles was produced.

This sample showed a value of $N + N_{-0.1} + N_{+0.1}$ less than 38% of the total number of opening portions, was inferior in conductivity, showed a large standard deviation in a total light transmittance, and was inferior in intrasurface uniformity of transparency.

(Comparative Example 4)

In the same manner as in Example 1, except that LUMIRROR (registered trade mark) T60, manufactured by TORAY INDUSTRIES, INC. was used for the substrate as a biaxially oriented polyethylene terephthalate film and an interlayer was not laminated, a conductive substrate laminated with the silver fine particles was produced.

This sample showed a value of $N + N_{-0.1} + N_{+0.1}$ less than 38% of the total number of opening portions, was inferior in transparency, showed a large standard deviation of a total light transmittance, and was inferior in intrasurface uniformity of conductivity.

(Example 10)

The metal fine particle layer-forming solution 1 was printed on one surface of a biaxially oriented polyethylene terephthalate film (LUMIRROR (registered trade mark) U94, manufactured by TORAY INDUSTRIES, INC.), by screen printing, in a random network form shown in Fig. 2. After drying at 150°C for 1 minute, a laminated substrate in which a silver fine particle layer was laminated in a random network form was obtained. The network had a line thickness of 2 µm and a line width of 35 µm.

Next, as the acetone treatment, the whole film was immersed in acetone (SP grade, manufactured by NACALAI TESQUE, INC.) at 25°C for 30 seconds. The film was taken out and dried at 25°C for 3 minutes.

Next, a solution prepared by diluting the resin layer-forming solution 1 with water until the solid content became 3% by weight was applied on a surface of a polyethylene terephthalate film, where a metal fine particle layer was formed, in a thickness of 7 µm (thickness based on polyethylene terephthalate). After drying at 150°C for 2 minutes, a resin layer was formed.

As the acid treatment, the whole film was subsequently immersed in 1 N hydrochloric acid (N/1-hydrochloric acid, manufactured by NACALAI TESQUE, INC.) at 25°C for 1 minute. The film was taken out and washed with water. The film was dried at 150°C for 1 minute. At this stage, surface specific resistance of the film before lamination of a plated metal layer was 5 Ω/sq.

In order to laminate a plated metal layer on the silver fine particle layer of this film, electrolytic copper plating was performed for 14 minutes by applying a current of 0.3 A per 100 cm$^2$ of the film using the electrolytic copper plating solution 1. The film was taken out, washed with water and dried at 120°C for 1 minute to obtain a conductive substrate laminated with a plated metal layer.

A laminate structure of the conductive substrate laminated with the plated metal layer was observed. As a result, the resin layer was laminated onto an opening portion of the metal fine particle layer, and the plated metal layer was laminated so as to cover a portion of the resin layer and the metal fine particle layer. The resin layer was contacted with the substrate, the metal fine particle layer and the plated metal layer.

(Example 11)

One surface of a biaxially oriented polyethylene terephthalate film (LUMIRROR (registered trade mark) U46, manufactured by TORAY INDUSTRIES, INC.) was subjected to a hydrophilization treatment, and the metal fine particle layer-forming solution 2 was applied on the hydrophilized layer. After letting stand it at 25°C for 10 minutes, a silver fine particle layer was laminated in a random network formed and then dried at 150°C for 2 minutes.

Next, as the acetone treatment, the whole film was immersed in acetone (SP grade, manufactured by NACALAI TESQUE, INC.) at 25°C for 30 seconds. The film was taken out and dried at 25°C for 3 minutes.

Next, a solution prepared by diluting the resin layer-forming solution 1 with water until the solid content became 3% by weight was applied on a surface of a polyethylene terephthalate film, where a metal fine particle layer was formed, in a thickness of 7 µm (thickness based on polyethylene terephthalate). After drying at 150°C for 2 minutes, a resin layer was formed.

Next, as the acid treatment, the whole film was subsequently immersed in 1 N hydrochloric acid (N/1-hydrochloric acid, manufactured by NACALAI TESQUE, INC.) at 25°C for 1 minute. The film was taken out and washed with water. The film was dried at 150°C for 2 minute. At this stage, surface specific resistance of the film before lamination of a plated metal layer was 4 Ω/sq.

In order to laminate a plated metal layer on the silver fine particle layer of this film, electrolytic copper plating was performed for 14 minutes by applying a current of 0.3 A per 100 cm$^2$ of the film using the electrolytic copper plating solution 1. The film was taken out, washed with water and dried at 120°C for 1 minute to obtain a conductive substrate laminated with a plated metal layer.

A laminate structure of the conductive substrate laminated with the plated metal layer was observed. As a result, the resin layer was laminated onto an opening portion of the metal fine particle layer, and the plated metal layer was laminated so as to cover a portion of the resin layer and the metal fine particle layer. The resin layer was contacted with the substrate, the metal fine particle layer and the plated metal layer.

(Example 12)

In the same manner as in Example 11, except that a solution prepared by diluting a resin layer-forming solution 2 with water until the solid content became 3% by weight was used as the resin layer-forming solution, a metal layer laminated substrate was prepared.

(Example 13)

In the same manner as in Example 11, except that a solution prepared by diluting a resin layer-forming solution 3 with water until the solid content became 3% by weight was used as the resin layer-forming solution, a metal layer laminated substrate was prepared.

(Example 14)

In the same manner as in Example 11, except that a solution prepared by diluting a resin layer-forming solution 4 with water until the solid content became 3% by weight was used as the resin layer-forming solution, a metal layer laminated substrate was prepared.

(Example 15)

In the same manner as in Example 11, except that the electrolytic copper plating time was determined as 7 minutes, a metal layer laminated substrate was produced.

(Example 16)

In the same manner as in Example 11, except that a solution prepared by diluting a resin layer-forming solution 1 with water until the solid content became 2% by weight was used as the resin layer-forming solution, a metal layer laminated substrate was prepared.

(Example 17)

In the same manner as in Example 11, except that a solution prepared by diluting a resin layer-forming solution 1 with water until the solid content became 5% by weight was used as the resin layer-forming solution, a metal layer laminated substrate was prepared.

(Example 18)

In order to provide a plated metal layer of the substrate (metal layer laminated substrate) produced in Example 11 with an antidazzling treatment, a dark-colored antidazzle layer was laminated by performing electrolytic blackening Ni plating at 28°C for 5 minutes while applying a current of 0.1 A per 100 cm$^2$ of the film, using an Enplate electrolytic Ni plating solution Z-80 manufactured by Meltex Inc.

(Comparative Example 5)

A sample was prepared in the same manner as in Example 2, except that a resin layer-forming solution 5 was used as the resin layer-forming solution.
Surface specific resistance of the film was 20 Ω/sq. after treating this sample with an acid and before laminating it with a plated metal layer, and it was larger in comparison with Example 2. The reason is considered as follows; a resin layer-forming solution containing an organic solvent was applied on a metal fine particle layer composed of metal fine particles dispersed in an organic solvent slightly soluble in water, so that a repulsive effect between a resin layer-forming solution and a metal fine particle layer was low. Thus the resin layer slightly covers the metal fine particle layer surface and acid treatment was hard to work accordingly.
It was possible to laminate the plated metal layer on this sample. As a result of the evaluation on adhesion after lamination of the plated metal layer laminate, the plated metal layer was easily peeled off.

(Comparative Example 6)

A sample was prepared in the same manner as in Example 11, except that the resin layer was not laminated.

(Comparative Example 7)

A sample was prepared in the same manner as in Example 10, except that the metal fine particle layer-forming solution 1 was printed by screen printing in a lattice pattern having a line thickness of 2 μm, a line width of 35 μm and a pitch of 300 μm. Moire was occurred in the substrate.

(Comparative Example 8)

In the same manner as in Example 11, except that the plated metal layer was not laminated, a sample was produced. The present sample was inferior in conductivity and lacked in magnetic field shielding properties.

(Comparative Example 9)

A sample was prepared in the same manner as in Example 11, except that a solution prepared by diluting the resin layer-forming solution 1 with water until the solid content became 20% by weight was used as the resin layer-forming solution and it was applied in a thickness of 50 μm (thickness based on polyethylene terephthalate). As a result, a metal fine particle layer was covered with a resin layer upon lamination of the resin layer and it was failed to laminate a plated metal layer.

The evaluation results of the characteristics in Examples 1 to 8, 10 to 18 and Comparative Examples 1 to are shown in Tables 1 to 4.

Table 1

| | Interlayer | Number maximum compactness | N | $N_{-0.1}$ | $N_{+0.1}$ | $N+N_{-0.1}+N_{+0.1}/$ number of total opening portions measured $\times$ 100(%) |
|---|---|---|---|---|---|---|
| Example 1 | Polyester/melamine crosslinking agent | 1.3 | 44 | 38 | 22 | 77.6 |
| Example 2 | Polyester/melamine crosslinking agent | 1.3 | 36 | 24 | 12 | 69.2 |
| Example 3 | Polyester/melamine crosslinking agent | 1.2 | 32 | 6 | 22 | 50.0 |
| Example 4 | Polyester/melamine crosslinking agent | 1.4 | 28 | 18 | 8 | 45.0 |
| Example 5 | Polyester/melamine crosslinking agent | 1.3 | 46 | 40 | 24 | 84.6 |
| Example 6 | Polyester/melamine crosslinking agent | 1.3 | 54 | 34 | 10 | 86.7 |
| Example 7 | Polyester/melamine crosslinking agent | 1.3 | 19 | 18 | 18 | 42.0 |
| Example 8 | Polyester/melamine crosslinking agent | 1.3 | 24 | 15 | 1 | 39.2 |
| Comparative Example 1 | None | 1.4 | 120 | 0 | 0 | 100 |
| Comparative Example 2 | Acrylic resin/ melamine crosslinking agent | 1.3 | 55 | 10 | 53 | 32.5 |
| Comparative Example 3 | Polyester/melamine crosslinking agent | 1.3 | 16 | 6 | 11 | 27.7 |
| Comparative Example 4 | None | 1.3 | 27 | 8 | 21 | 37.3 |

Table 2

| | Surface specific resistance ($\Omega$/sq.) | Standard deviations in surface specific resistance ($\Omega$/sq.) | Total light transmittance (%) | Standard deviations in total light transmittance (%) | Moiré phenomenon |
|---|---|---|---|---|---|
| Example 1 | 5 | 0.15 | 70 | 0.23 | A |
| Example 2 | 4 | 0.67 | 79 | 0.19 | A |
| Example 3 | 4 | 0.13 | 80 | 0.54 | A |
| Example 4 | 4 | 0.14 | 80 | 0.80 | A |
| Example 5 | 4 | 0.15 | 80 | 0.57 | A |
| Example 6 | 4 | 0.25 | 79 | 0.35 | A |
| Example 7 | 4 | 0.10 | 81 | 0.46 | A |
| Example 8 | 4 | 0.15 | 79 | 0.45 | A |
| Comparative Example 1 | 0.05 | 0.002 | 83 | 0.19 | B |
| Comparative Example 2 | 11 | 1.81 | 49 | 1.04 | A |
| Comparative Example 3 | immeasurable | immeasurable | 74 | 1.12 | A |
| Comparative Example 4 | 7 | 2.38 | 43 | 0.70 | A |

Table 3

| Properties of substrate before lamination of plated metal layer | | | | | |
|---|---|---|---|---|---|
| | Resin layer-forming solution | Solid content of resin layer solution (% by weight) | Coating thickness of resin layer solution ($\mu$m) | Surface specific resistance before lamination of plated metal layer ($\Omega$/sq.) | Adhesion properties before lamination of plated metal layer |
| Example 10 | Resin layer-forming solution 1 | 3 | 7 | 5 | A |
| Example 11 | Resin layer-forming solution 1 | 3 | 7 | 4 | A |
| Example 12 | Resin layer-forming solution 2 | 3 | 7 | 4 | A |
| Example 13 | Resin layer-forming solution 3 | 3 | 7 | 4 | A |
| Example 14 | Resin layer-forming solution 4 | 3 | 7 | 4 | A |

(continued)

| Properties of substrate before lamination of plated metal layer | | | | | |
|---|---|---|---|---|---|
| | Resin layer-forming solution | Solid content of resin layer solution (% by weight) | Coating thickness of resin layer solution ($\mu$m) | Surface specific resistance before lamination of plated metal layer ($\Omega$/sq.) | Adhesion properties before lamination of plated metal layer |
| Example 15 | Resin layer-forming solution 1 | 3 | 7 | 4 | A |
| Example 16 | Resin layer-forming solution 1 | 2 | 7 | 4 | A |
| Example 17 | Resin layer-forming solution 1 | 5 | 7 | 4 | A |
| Example 18 | Resin layer-forming solution 1 | 3 | 7 | 4 | A |
| Comparative Example 5 | Resin layer-forming solution 5 | 3 | 7 | 20 | A |
| Comparative Example 6 | None | - | 7 | 4 | B |
| Comparative Example 7 | Resin layer-forming solution 1 | 3 | 7 | 4 | A |
| Comparative Example 8 | Resin layer-forming solution 1 | 3 | 7 | 4 | A |

Table 4

| | Shape of network | Thickness of plated metal layer (μm) | Surface specific resistance (Ω/sq.) | Adhesion properties | Resistance against Moire phenomenon | Electromagnetic wave shielding properties (dB) | | Total light transmittance (%) | Maximum reflectance in visible ray region (%) |
|---|---|---|---|---|---|---|---|---|---|
| Properties of substrate after lamination of plated metal layer | | | | | | | | | |
| | | | | | | Electric field | Magnetic field | | |
| Example 10 | Random | 3 | 0.08 | A | A | 50 (pass) | 10 (pass) | 70 | 32 |
| Example 11 | Random | 3 | 0.08 | A | A | 50 (pass) | 10 (pass) | 73 | 31 |
| Example 12 | Random | 3 | 0.08 | A | A | 50 (pass) | 10 (pass) | 73 | 31 |
| Example 13 | Random | 3 | 0.08 | A | A | 50 (pass) | 10 (pass) | 73 | 31 |
| Example 14 | Random | 3 | 0.08 | A | A | 50 (pass) | 10 (pass) | 73 | 31 |
| Example 15 | Random | 1.5 | 0.15 | A | A | 50 (pass) | 7 (pass) | 75 | 30 |
| Example 16 | Random | 3 | 0.08 | A | A | 50 (pass) | 10 (pass) | 73 | 31 |
| Example 17 | Random | 3 | 0.08 | A | A | 50 (pass) | 10 (pass) | 73 | 31 |
| Example 18 | Random | 3 | 0.08 | A | A | 50 (pass) | 10 (pass) | 73 | 9 |
| Comparative Example 5 | Random | 3 | 0.08 | B | A | 50 (pass) | 10 (pass) | 73 | 31 |
| Comparative Example 6 | Random | 3 | 0.08 | B | A | 50 (pass) | 10 (pass) | 73 | 31 |
| Comparative Example 7 | Latticeshape | 3 | 0.08 | A | B | 50 (pass) | 10 (pass) | 75 | 31 |

(continued)

| | Shape of network | Thickness of plated metal layer (μm) | Surface specific resistance (Ω/sq.) | Adhesion properties | Resistance against Moire phenomenon | Electromagnetic wave shielding properties (dB) | | Total light transmittance (%) | Maximum reflectance in visible ray region (%) |
|---|---|---|---|---|---|---|---|---|---|
| Properties of substrate after lamination of plated metal layer | | | | | | Electric field | Magnetic field | | |
| Comparative Example 8 | Random | Not laminated | 4 | - | A | 50 (pass) | 1 (fail) | 80 | 16 |

INDUSTRIAL APPLICABILITY

The present invention relates to a conductive substrate and an electromagnetic wave shielding substrate for a plasma display which achieve uniform transparency and conductivity over a large area, and are also less likely to cause Moire phenomenon, and a method for producing the same. According to a preferred aspect of the present invention, high-level conductivity and transparency are also obtained. The conductive substrate of the present invention is suitably used as an electromagnetic wave shielding member of a plasma display panel, and also suitably used for various circuit boards and solar batteries because of its excellent transparency and conductivity.

**Claims**

1.  A conductive substrate comprising:

a metal fine particle layer laminated onto at least one surface of a substrate in a random network form;
a resin layer laminated at an opening portion of a network of the metal fine particle layer so as to be brought into contact with the metal fine particle layer; and
a plated metal layer laminated onto the metal fine particle layer so as to be brought into contact with the resin layer, wherein a resin composing the resin layer is a resin having an anionic ionic group.

2.  The conductive substrate according to claim 1, wherein the resin having an anionic ionic group is polyester having an anionic ionic group and/or polyurethane having an anionic ionic group.

3.  A conductive substrate in which a metal fine particle layer is laminated onto a substrate in a network form, wherein:

a sum $(N+N_{-0.1}+N_{+0.1})$ of the number $(N)$ of an opening portion having a number maximum compactness, the number $(N_{-0.1})$ of an opening portion having a compactness 0.1 smaller than the number maximum compactness and the number $(N_{+0.1})$ of an opening portion having a compactness 0.1 larger than the number maximum compactness is 38% to 90% of a total number of the opening portion,
where a compactness of each opening portion of the network form is defined as a value calculated from the following formula (1) and rounded to one decimal place, and

$$(\text{perimeter of opening portion})^2/(4 \times \pi \times (\text{area of opening portion})) \qquad (1)$$

the number maximum compactness is a compactness where the number of the opening portions is maximized.

4.  The conductive substrate according to claim 3, wherein a plated metal layer is laminated onto the metal fine particle layer.

5.  The conductive substrate according to any one of claims 1 to 4, wherein an interlayer containing a polyester resin and a crosslinking agent is laminated between the substrate and the metal fine particle layer.

6.  The conductive substrate according to claim 5, wherein wetting tension of the substrate and/or the interlayer is 40 mN/m or more.

7.  The conductive substrate according to any one of claims 1 to 6, wherein the metal fine particle layer is a layer laminated by applying a solution in which metal fine particles are self-assembled in a network form onto the substrate.

8.  The conductive substrate according to claim 3, wherein the number maximum compactness is within a range from 1.1 to 1.7.

9.  The conductive substrate according to claim 3, wherein surface specific resistance is 40 Ω/sq. or less.

10. The conductive substrate according to any one of claims 1 to 9, wherein a total light transmittance is 50% or more.

**11.** The conductive substrate according to claim 1, wherein the resin composing the resin layer is a water-borne resin.

**12.** The conductive substrate according to any one of claims 1 to 11, wherein the metal fine particles composing the metal fine particle layer are dispersed in an organic solvent slightly soluble in water.

**13.** The conductive substrate according to claim 1 or 4, wherein the plated metal layer has a thickness of 1.5 $\mu$m or more.

**14.** An electromagnetic wave shielding substrate for a plasma display, using the conductive substrate according to any one of claims 1 to 13.

**15.** A method for producing the conductive substrate according to any one of claims 1 to 13, which comprises laminating an interlayer containing a polyester resin and a crosslinking agent onto at least one surface of a substrate, and laminating a metal fine particle layer onto the surface, onto which the interlayer was laminated, in a network form.

**16.** The method for producing the conductive substrate according to claim 15, wherein the metal fine particle layer is laminated onto the surface, onto which the interlayer having adjusted wetting tension of 40 mN/m or more is laminated, of the substrate.

**17.** A method for producing a conductive substrate according to claim 1 or 4, which comprises a step of laminating a metal fine particle layer onto a substrate in a random network form; a step of laminating a resin layer having an anionic ionic group onto an opening portion of a network of the metal fine particle layer so as to be brought into contact with the metal fine particle layer; and a step of laminating a plated metal layer onto the metal fine particle layer so as to be brought into contact with the resin layer.

**18.** The method for producing the conductive substrate according to any one of claims 15 to 17, wherein a metal fine particle layer is laminated in a network form by applying a solution in which metal fine particles are self-assembled in a network form on the substrate.

**19.** The method for producing the conductive substrate according to any one of claims 15 to 18, wherein the metal fine particle layer is subjected to an acid treatment after laminating it in a network form.

**20.** The method for producing the conductive substrate according to claim 19, wherein the metal fine particle layer is subjected to the acid treatment after treating it with an organic solvent.

Fig.1

Fig.2

Fig.3

**INTERNATIONAL SEARCH REPORT**

| International application No. |
| --- |
| PCT/JP2008/058526 |

A. CLASSIFICATION OF SUBJECT MATTER
*H05K9/00*(2006.01)i, *G09F9/00*(2006.01)i, *G09F9/30*(2006.01)i

According to International Patent Classification (IPC) or to both national classification and IPC

B. FIELDS SEARCHED

Minimum documentation searched (classification system followed by classification symbols)
H05K9/00, G09F9/00, G09F9/30

Documentation searched other than minimum documentation to the extent that such documents are included in the fields searched
Jitsuyo Shinan Koho          1922-1996    Jitsuyo Shinan Toroku Koho    1996-2008
Kokai Jitsuyo Shinan Koho    1971-2008    Toroku Jitsuyo Shinan Koho    1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2006-313891 A  (Toray Industries, Inc.), 16 November, 2006 (16.11.06), Full text; Fig. 1 & WO 2007/114076 A1 | 1-20 |
| A | WO 2006/040989 A1  (Toray Industries, Inc.), 20 April, 2006 (20.04.06), Full text; Figs. 1 to 5 & US 2007/0264530 A1    & EP 1850353 A1 & CA 2580842 A            & CN 1036201 A | 1-20 |
| A | JP 2006-32197 A  (Sumitomo Metal Mining Co., Ltd.), 02 February, 2006 (02.02.06), Full text; Figs. 1 to 3 (Family: none) | 1-20 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 03 July, 2008 (03.07.08) | 15 July, 2008 (15.07.08) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2008/058526 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2006-127929 A  (Mitsubishi Chemical Corp.), 18 May, 2006 (18.05.06), Full text; Figs. 1 to 3 (Family: none) | 1-20 |
| A | JP 2001-343520 A  (Fuji Photo Film Co., Ltd.), 14 December, 2001 (14.12.01), Full text; Figs. 1 to 6 & US 2002/0050783 A1 | 1-20 |
| A | JP 4-217397 A  (Comerics, Inc.), 07 August, 1992 (07.08.92), Full text; Figs. 1 to 4 & EP 446038 A2            & CA 2036868 A1 | 1-20 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001343520 A
- JP 2006127929 A
- JP 10340629 A
- JP 10182191 A